(19) **Europäisches Patentamt / European Patent Office / Office européen des brevets**

(11) **EP 4 651 667 A1**

(12) **EUROPEAN PATENT APPLICATION**
published in accordance with Art. 153(4) EPC

(43) Date of publication:
**19.11.2025 Bulletin 2025/47**

(21) Application number: **23936069.6**

(22) Date of filing: **10.05.2023**

(51) International Patent Classification (IPC):
**H10B 43/50** (2023.01)

(52) Cooperative Patent Classification (CPC):
**H10B 43/20; H10B 43/27; H10B 43/35;**
**H10D 30/0413; H10D 30/699; H10D 84/0128;**
**H10D 84/038;** H10B 43/10

(86) International application number:
**PCT/CN2023/093233**

(87) International publication number:
**WO 2024/229747 (14.11.2024 Gazette 2024/46)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Yangtze Memory Technologies Co.,**
**Ltd.**
**Wuhan, Hubei 430205 (CN)**

(72) Inventors:
• **LUO, Jiaming**
  **Wuhan, Hubei 430000 (CN)**
• **PU, Hao**
  **Wuhan, Hubei 430000 (CN)**
• **LIN, Jie**
  **Wuhan, Hubei 430000 (CN)**
• **YANG, Yonggang**
  **Wuhan, Hubei 430000 (CN)**
• **XIA, Yuping**
  **Wuhan, Hubei 430000 (CN)**

(74) Representative: **Lippert Stachow Patentanwälte**
**Rechtsanwälte**
**Partnerschaft mbB**
**Frankenforster Strasse 135-137**
**51427 Bergisch Gladbach (DE)**

(54) **SEMICONDUCTOR DEVICE AND MANUFACTURING METHOD THEREFOR, AND STORAGE SYSTEM**

(57) Examples of the present application disclose a semiconductor device and a fabrication method thereof and a memory system. The semiconductor device includes: a stack structure including first regions and second regions; channel structures that are located in the first regions and penetrate through the stack structure along a first direction; and gate line isolation structures that are located in the second regions and extend along a second direction, wherein the gate line isolation structures penetrate through the stack structure along the first direction and are in a concavo-convex shape along a third direction.

| | |
|---|---|
| Provide a stack layer, wherein the stack layer comprises dielectric layers and sacrificial layers stacked alternately, and the stack layer comprises first regions and second regions | S100 |
| Form a plurality of channel holes penetrating through the stack layer along a first direction in the first regions, and form a plurality of first dummy channel holes penetrating through the stack layer along the first direction in the second regions | S200 |
| Form a plurality of channel structures in the plurality of channel holes | S300 |
| Form gate line slit trenches that extend in a second direction and surround the plurality of first dummy channel holes, wherein the second direction intersects the first direction | S400 |
| Form gate line isolation structures in the gate line slit trenches, wherein the gate line isolation structures are in a concavo-convex shape along a third direction that intersects the first direction and the second direction | S500 |

**FIG. 27**

# EP 4 651 667 A1

**Description**

TECHNICAL FIELD

The present application relates to the technical field of semiconductors, and particularly to a semiconductor device, a fabrication method thereof, and a memory system.

BACKGROUND

As feature sizes of memory cells approach the lower limits of processes, planar processes and fabrication technologies become challenging and costly, which leads to the storage density of 2D structure memories approaching its upper limit.

In order to overcome the limitations of the 2D structure memories, the industry has developed a memory with a three-dimensional structure, in which memory cells are arranged on a substrate three-dimensionally to increase the storage density.

The three-dimensional memory may comprise semiconductor structures as memory arrays, and periphery devices. How to improve the fabrication yield and reliability of the above-mentioned semiconductor structures is a problem to be addressed.

SUMMARY

The present application provides a semiconductor device, a fabrication method thereof, and a memory system, to improve a yield and reliability of the semiconductor device.

In a first aspect, the present application provides a fabrication method of a semiconductor device, which comprises:

providing a stack layer, wherein the stack layer comprises dielectric layers and sacrificial layers stacked alternately, and the stack layer comprises first regions and second regions;
forming a plurality of channel holes penetrating through the stack layer along a first direction in the first regions, and forming a plurality of first dummy channel holes penetrating through the stack layer along the first direction in the second regions;
forming a plurality of channel structures in the plurality of channel holes;
forming gate line slit trenches that extend in a second direction and surround the plurality of first dummy channel holes, wherein the second direction intersects the first direction; and
forming gate line isolation structures in the gate line slit trenches, wherein the gate line isolation structures are in a concavo-convex shape along a third direction that intersects the first direction and the second direction.

In an implementation of the present application, forming the gate line slit trenches that extend in the second direction and surround the plurality of first dummy channel holes comprises:
etching the plurality of first dummy channel holes to form a plurality of second dummy channel holes, and connecting the plurality of second dummy channel holes together in the second direction to form the gate line slit trenches.

In an implementation of the present application, before forming the plurality of channel structures in the plurality of channel holes, the fabrication method further comprises:
filling a sacrificial material in the channel holes and the first dummy channel holes, and removing the sacrificial material in the channel holes.

In an implementation of the present application, after filling the sacrificial material in the channel holes and the first dummy channel holes, and before removing the sacrificial material in the channel holes, the fabrication method further comprises:
forming a cap layer on top of the stack layer, and removing the cap layer above the channel holes.

In an implementation of the present application, before forming the gate line slit trenches that extend in the second direction and surround the plurality of first dummy channel holes, the fabrication method further comprises:
removing the sacrificial material in the first dummy channel holes.

In an implementation of the present application, after forming the plurality of channel structures in the plurality of channel holes, and before removing the sacrificial material in the first dummy channel holes, the fabrication method further comprises: forming a protective layer on top of the stack layer.

In an implementation of the present application, the protective layer includes polysilicon.

In an implementation of the present application, before forming the gate line isolation structures in the gate line slit trenches, the fabrication method further comprises:

2

replacing the sacrificial layers in the stack layer with gate line layers.

In an implementation of the present application, shapes of the first dummy channel holes include any one of an ellipse or a circle, and shapes of the channel holes include a circle.

In an implementation of the present application, the stack layer comprises a core area and a stair step area; and the plurality of first dummy channel holes with equal diameters along the third direction are formed in the core area and the stair step area.

In an implementation of the present application, the stack layer comprises a core area and a stair step area; and diameters of the plurality of first dummy channel holes formed in the core area along the third direction are smaller than diameters of the plurality of first dummy channel holes formed in the stair step area along the third direction.

In an implementation of the present application, forming the plurality of channel holes penetrating through the stack layer along the first direction in the first regions and forming the plurality of first dummy channel holes penetrating through the stack layer along the first direction in the second regions in the stack layer comprises:

forming a composite photolithography layer on the dielectric layer at the top of the stack layer, and forming a plurality of first trenches and a plurality of second trenches in the composite photolithography layer, wherein the first trenches are located within the first regions, and the second trenches are located within the second regions;

etching the stack layer within the first regions through the first trenches to form the plurality of channel holes; and etching the stack layer within the second regions through the second trenches to form the plurality of first dummy channel holes.

In an implementation of the present application, the plurality of channel holes and the plurality of first dummy channel holes are formed in the same process.

In an implementation of the present application, forming the composite photolithography layer on the dielectric layer at the top of the stack layer comprises:

forming a stop layer on the dielectric layer at the top of the stack layer, and forming a first mask layer on the stop layer; and

etching the first mask layer through the stop layer until exposing the dielectric layer at the top of the stack layer, so as to form the composite photolithography layer.

In an implementation of the present application, the first mask layer comprises a hard mask layer or a photoresist layer.

In order to solve the above problem, examples of the present disclosure further provide a semiconductor device, comprising:

a stack structure, wherein the stack structure comprises dielectric layers and gate line layers stacked alternately, and the stack structure comprises first regions and second regions;

channel structures that are located in the first regions and penetrate through the stack structure along a first direction; and

gate line isolation structures that are located in the second regions and extend along a second direction, the gate line isolation structures penetrating through the stack structure along the first direction, and the gate line isolation structures being in a concavo-convex shape along a third direction, wherein the second direction intersects the first direction, and the third direction intersects the first direction and the second direction.

In an implementation of the present application, the semiconductor device further comprises: a protective layer disposed on top of the stack structure.

In an implementation of the present application, the gate line isolation structures comprise sidewalls extending along the second direction, the sidewalls comprise a plurality of substructures connected end to end, and two adjacent ones of the substructures are not coplanar.

In an implementation of the present application, the stack structure comprises a core area and a stair step area; and sizes of the gate line isolation structures located in the core area along the third direction are equal to sizes of the gate line isolation structures located in the stair step area along the third direction.

In an implementation of the present application, the stack structure comprises a core area and a stair step area; and sizes of the gate line isolation structures located in the core area along the third direction are smaller than sizes of the gate line isolation structures located in the stair step area along the third direction.

In order to solve the above problem, examples of the present disclosure further provide a memory system comprising: a controller and a three-dimensional memory, wherein the controller is coupled to the three-dimensional memory and configured to control the three-dimensional memory to store data, and the three-dimensional memory comprises the semiconductor device of any one of the above examples.

The present application has the advantageous effects that: the stack layer comprises the first regions and the second regions, the plurality of channel holes penetrating through the stack layer along a first direction are formed in the first regions, and the plurality of first dummy channel holes penetrating through the stack layer along the first direction are formed in the second regions. Then, the plurality of channel structures are formed in the plurality of channel holes, the gate line slit trenches that extend along the second direction and surround the plurality of first dummy channel holes are formed, and the second direction intersects the first direction. The gate line isolation structures are formed in the gate line slit trenches, and are in a concavo-convex shape along the third direction. The present application can improve the yield and the reliability of the device.

BRIEF DESCRIPTION OF THE DRAWINGS

The drawings to be used in description of examples will be briefly introduced below in order to illustrate the technical solutions in the examples of the present application more clearly. Apparently, the drawings described below are only some examples of the present application. Those skilled in the art may obtain other drawings according to these drawings without creative work.

FIG. 1 is a schematic top view of a semiconductor device provided by examples of the present application;
FIGs. 2-3 are schematic structure views of several stages in a semiconductor device shown in FIG. 1;
FIGs. 4-16 are schematic structure views of several stages in a semiconductor device provided by examples of the present application;
FIGs. 17-26 are schematic top views of several stages in a semiconductor device provided by examples of the present application;
FIG. 27 is a process flow diagram of a fabrication method of a semiconductor device provided by examples of the present application; and
FIG. 28 is a schematic structure diagram of a memory system provided by examples of the present application.

DETAILED DESCRIPTION

The technical solutions in examples of the present application will be described below clearly and completely in conjunction with the drawings in the examples of the present application. Apparently, the examples described are only part of, but not all of, the examples of the present application. All other examples obtained by those skilled in the art based on the examples in the present application without creative work shall fall in the scope of protection of the present application.

In the description of the present application, it should be understood that the terms "first" and "second" are only for the purpose of description, and cannot be construed as indicating or implying relative importance or implicitly indicating the number of the indicated technical features. Thus, features defined by "first" and "second" may explicitly or implicitly include one or more of the features. In the description of the present application, "a plurality of" means two or more, unless otherwise defined expressly and specifically.

In the description of the present application, it is to be noted that, unless otherwise specified and defined expressly, the terms "mounted", "connected" and "connecting" should be interpreted in a broad sense, which, for example, may be fixed connection, detachable connection, or integrated connection; may be either mechanical connection or electrical connection or may be intercommunication; may be either direct connection or indirect connection through intermediate media, and may be connection inside two elements or an interaction relationship of two elements. Those of ordinary skill in the art may understand the specific meanings of the above terms in the present application according to specific conditions.

In the present application, unless otherwise specified and defined expressly, a first feature being "on" or "underneath" a second feature may include the first feature being in direct contact with the second feature, and may also include the first feature being in contact with the second feature through another feature therebetween instead of being in direct contact with the second feature. Moreover, the first feature being "over", "above" and "on" the second feature includes the first feature being above or directly above the second feature, or only means that the level of the first feature is higher than that of the second feature. The first feature being "under", "below" and "underneath" the second feature includes the first feature being below or directly below the second feature, or only means that the level of the first feature is less than that of the second feature.

As used in the present application, the term "layer" refers to a material portion including a region with a thickness. A layer has a top side and a bottom side, wherein the bottom side of the layer is relatively close to the substrate while the top side is relatively far away from the substrate. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any set of horizontal planes between, or at, a top surface and a bottom surface of the continuous structure. A layer can extend horizontally, vertically, and/or along a tapered surface. A substrate can be a layer, can include one or more layers therein, and/or can have one or more layers on the substrate, above the substrate, and/or beneath the substrate. A layer can include multiple layers. For example, an interconnection layer can include one or more gate line layers and contact layers in which contacts, interconnection lines and one or more dielectric layers are formed.

It is to be noted that the diagrams provided in the examples of the present application only illustrate a basic concept of the present application in a schematic way. The diagrams only show components related to the present application, and are not drawn according to the number, shapes and sizes of components during actual implementation. During the actual implementation, the shapes, number and scale of various components may be changed freely, and layouts of the components may also be more complex.

The disclosure below provides many different implementations or examples to achieve different structures of the present application. In order to simplify the present application, components and settings of specific examples are described below. Of course, they are merely examples, and are not intended to limit the present application. In addition, the present application may repeat the reference numerals and/or reference letters in different examples, and such repetitions are for the purpose of simplification and clarity, and do not indicate in themselves the relationships between various implementations and/or settings as discussed. In addition, the present application provides examples of various specific processes and materials. However, those of ordinary skill in the art may realize the application of other processes and/or use of other materials.

A three-dimensional memory is applied more and more widely due to a large storage density and a high storage capacity. A fabrication process flow of the three-dimensional memory in the related art typically includes several main process operations as follows: forming channel holes (CHs) in a core area of a stack structure, forming a staircase structure (SS) at a periphery of the core area, forming dummy channel holes (DCHs) in the staircase structure, then replacing sacrificial layers in a stack layer to form gate lines (GLs), and forming gate contacts (GTs) leading out of each gate line layer in the staircase structure, etc.

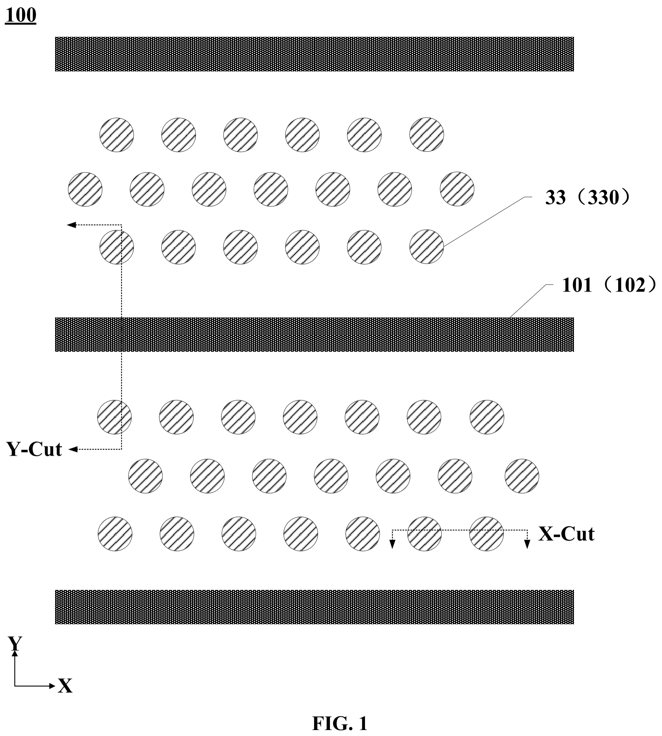

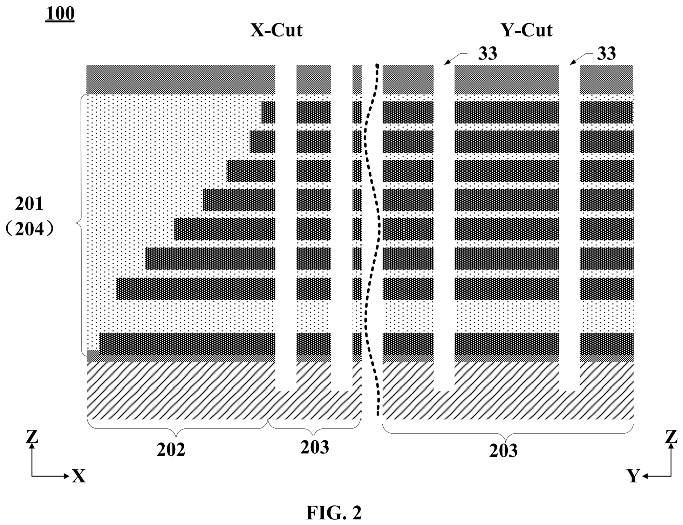

For example, FIG. 1 is a schematic structure top view of a 3D NAND memory, FIGs. 2-3 are schematic structure views of a 3D NAND memory, and FIGs. 2-3 are schematic sectional views of the 3D NAND memory in FIG. 1 along an X-Cut line and a Y-Cut line. As shown in FIGs. 2 to 3, first, channel holes 33 penetrating through a stack layer 201 are formed, and channel structures 330 are formed in the channel holes 33. Then, a gate line slit trench 101 that extends along a second direction (e.g., an X axis direction) and penetrates through the stack layer 201 is formed at a preset position between the channel structures 330. Then, a gate line isolation structure 102 is formed in the gate line slit trench 101 to obtain the 3D NAND memory as shown in FIG. 1.

However, since an aspect ratio of the gate line slit trench 101 formed is greater than aspect ratios of the channel holes, and a sidewall of the gate line isolation structure 102 formed in the gate line slit trench 101 has a linear shape, a cut of the gate line isolation structure 102 is fragile. Moreover, the gate line isolation structure 102 extends a long distance along an extending direction thereof, the sidewall of the gate line isolation structure 102 is equivalent to a wall with a very large height, and tilting or distortion is prone to occur under a stress, thereby causing the gate line isolation structure 102 to fail to keep its shape. As a result, continuity of the conductive material in the gate line isolation structure 102 cannot be ensured after a conductive material has been filled, thereby resulting in failure of the device caused by a short circuit of the gate line.

In addition, with the increasing of the number of memory layers, the aspect ratios of the channel holes 33 and the gate line slit trench 101 to be etched are continuously increasing, which results in a higher level of difficulty for the etching process. As shown in FIGs. 2 to 3, the channel holes 33 and the gate line slit trench 101 are etched separately, such that the cost is high, and the channel holes 33 and the gate line slit trench 101 may tilt and interfere with each other, which results in some yield loss. Due to the problem of tilting and mutual interference caused by the increasing aspect ratios of the channel holes 33 and the gate line slit trench 101 to be etched, it is unlikely to further develop and produce a 3D NAND memory with more memory layers.

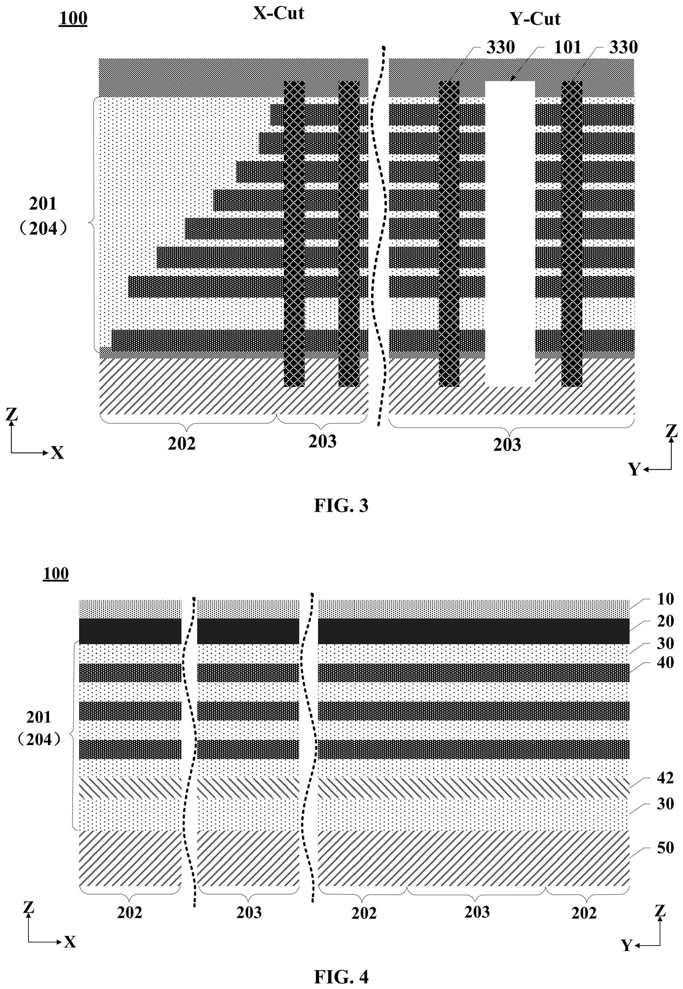

In order to solve the above problem, referring to FIGs. 4 to 28, examples of the present application provide a semiconductor device 100, a fabrication method thereof, and a memory system. In the present application, while a stack layer 201 is etched in first regions 202 to form channel holes 33, the stack layer 201 is etched in second regions 203 through the same process to form first dummy channel holes 34. Subsequently, through a series of processes, gate line slit trenches 101 are formed by using the first dummy channel holes 34 of the second regions 203, thereby achieving one-time etching formation of the channel holes 33 of the first regions 202 and the gate line slit trenches 101 of the second regions 203. The fabrication cost of the semiconductor device 100 of the present application is low, and the problem of the yield loss caused by the tilting between the channel structures 330 and the gate line isolation structures 102 is solved.

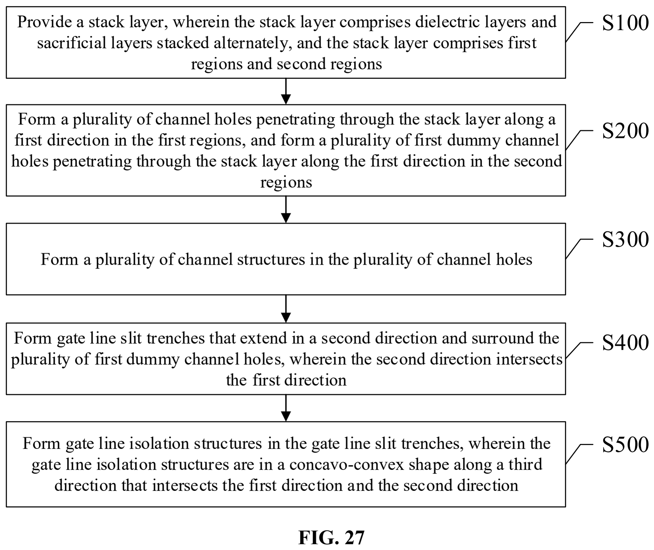

Referring to FIG. 27 which is a process flow diagram of a fabrication method of a semiconductor device 100 provided by examples of the present application, the specific process flow of operations comprises the following operations with reference to the structure views in FIGs. 4 to 26:

operation S100, providing a stack layer 201, wherein the stack layer 201 comprises dielectric layers 30 and sacrificial layers 40 stacked alternately, and the stack layer 201 comprises first regions 202 and second regions 203.

In some examples of the present application, a stack layer 201 as shown in FIG. 4 is provided, and comprises the dielectric layers 30 and the sacrificial layers 40 that are stacked alternately in a first direction and extend along a second direction and a third direction. The second direction intersects the first direction, and the third direction intersects the first direction and the second direction. Here, the second direction intersecting the first direction may be interpreted as an included angle between the second direction and the first direction being less than or equal to 90 degrees, and the third direction intersecting the first direction and the second direction may be interpreted as an included angle between the third direction and a plane where the first direction and the second direction are located being less than or equal to 90 degrees. In some specific examples of the present application, the included angle between the second direction and the first direction is equal to 90 degrees, and the included angle between the third direction and the plane where the first direction and the second direction are located is equal to 90 degrees.

In some specific examples, the first direction may be interpreted as a Z axis direction as shown in FIGs. 4-26, the second direction may be interpreted as an X axis direction as shown in FIGs. 4-26, and the third direction may be interpreted as a Y axis direction as shown in FIGs. 4-26.

In an example, first, a substrate 50 is provided, and extends in the second direction (the X axis direction) and the third direction (the Y axis direction) to form a substrate stack surface, and the stack layer 201 is formed on the stack surface. As an example, the substrate 50 may be selected according to actual requirements of the device, for example, may include a silicon substrate, a germanium (Ge) substrate, a silicon germanium (SiGe) substrate, an SOI (Silicon-on-Insulator) substrate, or a GOI (Germanium-on-Insulator) substrate, or the like. In this example, the substrate 50 includes a monocrystalline silicon substrate.

In some examples of the present application, the substrate 50 includes a semiconductor substrate. For example, the substrate may include a monocrystalline silicon (Si) substrate, a monocrystalline germanium (Ge) substrate, a silicon on insulator (SOI) substrate, or a germanium on insulator (GOI) substrate, or the like. It is to be noted that, the substrate may be a substrate after ion doping. In an example, the substrate may be a P-type doped substrate, and may also be an N-type doped substrate. A suitable material may be selected as the substrate according to the actual requirements, to which the present application imposes no specific limitation. Of course, in other examples, the material of the substrate may also include a semiconductor or a compound including other elements. For example, the substrate may be a gallium arsenide (GaAs) substrate, an indium phosphide (InP) substrate, or a silicon carbide (SiC) substrate, or the like.

In some examples of the present application, the stack layer 201 with a multiple-layer structure is formed on the stack surface by selecting a deposition method according to actual requirements. The number of layers of the stack layer 201 in FIGs. 4 to 16 is only an example. For example, the number of the dielectric layers 30 and the sacrificial layers 40 in the stack layer 201 may include 32 layers, 64 layers, 96 layers, or 128 layers, etc. In an example, the number of the dielectric layers 30 and the sacrificial layers 40 in the stack layer 201 may be set according to actual requirements, that is, the number of layers of the stack layer 201 is not limited.

In some examples of the present application, a base plate may be provided, and the stack layer 201 is formed on the base plate, and comprises the dielectric layers 30 and the sacrificial layers 40 that extend along the second direction (e.g., the X axis direction) and the third direction (e.g., the Y axis direction) and are stacked alternately along the first direction (the Z axis direction). In some examples, the base plate may be removed in a subsequent manufacturing process to obtain the semiconductor device 100 that does not include the substrate 50, and may also be remained to form the substrate 50 to obtain the semiconductor device 100 that includes the substrate 50, to which no specific limitation is imposed.

In some examples of the present application, the materials of the sacrificial layers 40 and the dielectric layers 30 are made of an insulation material that includes, but is not limited to, a combination of any of one or more of polysilicon, silicon nitride, silicon oxide and aluminum oxide. Here, silicon oxide refers to a silicon-oxygen compound, such as $Si_xO_y$, and silicon nitride refers to a nitrogen-silicon compound, such as $Si_xN_y$. In an example, the sacrificial layers 40 may include silicon nitride, and the dielectric layers 30 may include silicon oxide. The sacrificial layers 40 and the dielectric layers 30 have different etching selectivities, and a deposition method of the sacrificial layers 40 and the dielectric layers 30 may adopt, but is not limited to, chemical vapor deposition (CVD), physical vapor deposition (PVD), plasma-enhanced CVD (PECVD), sputtering, metal-organic chemical vapor deposition (MOCVD), and atomic layer deposition (ALD), etc.

Referring to FIGs. 4 to 19, 25 and 26, the stack layer 201 is divided into the first regions 202 and the second regions 203. It is to be noted that the first regions 202 and the second regions 203 are distinguished only for ease of illustration, and do not represent physical splitting of the stack layer 201 or the size of the stack layer 201.

Operation S200, forming a plurality of channel holes 33 penetrating through the stack layer 201 along the first direction (e.g., the Z axis direction) in the first regions 202, and forming a plurality of first dummy channel holes 34 penetrating through the stack layer 201 along the first direction in the second regions 203.

In some implementations of the present application, the operation S200 forming the plurality of channel holes 33 penetrating through the stack layer 201 along the first direction in the first regions 202 and forming the plurality of first dummy channel holes 34 penetrating through the stack layer 201 along the first direction in the second regions 203 in the stack layer 201 comprises:

operation S210, forming a composite photolithography layer 11 on the dielectric layer 30 at the top of the stack layer 201; and forming a plurality of first trenches 31 and a plurality of second trenches 32 in the composite photolithography layer 11, wherein the first trenches 31 are located within the first regions 202, and the second trenches 32 are located within the second regions 203.

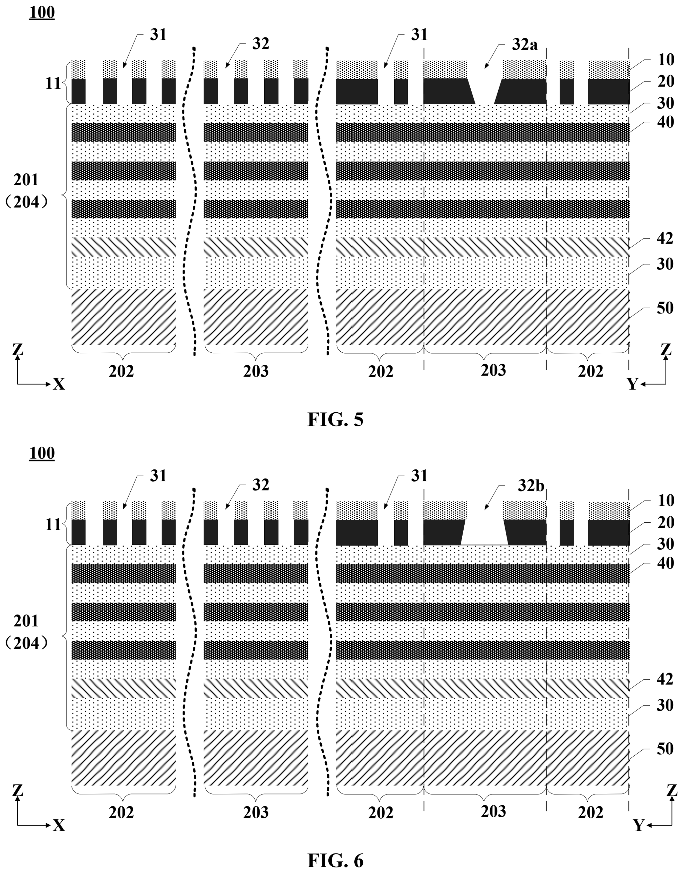

In some examples of the present application, referring to a structure formed in operation S210 as shown in FIGs. 4 to 6, the structure as shown in FIGs. 5 and 6 comprises the substrate 50, the stack layer 201 disposed in the first direction (the Z axis direction), a plurality of the first regions 202 disposed in the stack layer 201, and the second regions 203 each located between two of the first regions 202. The composite photolithography layer 11 is disposed on the dielectric layer 30 at the top of the stack layer 201. The plurality of first trenches 31 formed in the composite photolithography layer 11 are located in the first regions 202. The stack layer 201 of the first regions 202 aligned to the first trenches 31 is etched to form the channel holes 33 in the examples below. The plurality of second trenches 32 in the composite photolithography layer 11 are located in the second regions 203. The stack layer 201 of the second regions 203 aligned to the second trenches 32 is etched to form the first dummy channel holes 34 in the examples below.

In some implementations of the present application, the operation S210 forming the composite photolithography layer 11 on the dielectric layer 30 at the top of the stack layer 201 comprises:

operation S211, forming a stop layer 20 on the dielectric layer 30 at the top of the stack layer 201 and forming a first mask layer 10 on the stop layer 20; and
operation S212, etching the first mask layer 10 through the stop layer 20 until exposing the dielectric layer 30 at the top of the stack layer, so as to form the composite photolithography layer 11.

In some examples of the present application, referring to FIGs. 4 to 6, in the present application the plurality of channel holes 33 penetrating through the stack layer 201 located in the first regions 202 along the first direction (e.g., the Z axis direction) are formed using an etching process, and the plurality of first dummy channel holes 34 penetrating through the stack layer 201 located in the second regions 203 along the first direction (e.g., the Z axis direction) are also formed using the etching process. The etching process used by the examples of the present application may include dry etching or wet etching.

In some examples of the present application, as shown in FIG. 4, the stop layer 20 and the patterned first mask layer 10 are sequentially formed on the dielectric layer 30 at the top of the stack layer 201 through a deposition process. The material of the dielectric layer 30 may include silicon oxide, and the material of the stop layer 20 may include silicon nitride or silicon oxynitride. In a practical application, the stop layer 20 and the first mask layer 10 may be formed through a deposition process, such as chemical vapor deposition (CVD), physical vapor deposition (PVD), plasma-enhanced CVD (PECVD), sputtering, metal-organic chemical vapor deposition (MOCVD) or atomic layer deposition (ALD).

In some implementations of the present application, the first mask layer 10 comprises a hard mask layer or a photoresist layer.

In some examples of the present application, the first mask layer 10 may be a photoresist (PR) layer, and the photoresist layer is formed on the stop layer 20. The photoresist layer is exposed through a photomask, and the exposed photoresist layer is developed to remove the photoresist layer not irradiated, thereby forming the patterned photoresist layer on the stop layer 20. In some examples, the first mask layer 10 may also be a hard mask (HM) layer.

In some examples of the present application, as shown in FIGs. 5 and 6, the patterned first mask layer 10 has photolithography openings. By taking the patterned first mask layer 10 as a mask, the stop layer 20 is etched to form the first trenches 31 and the second trenches 32 corresponding to the photolithography openings in the stop layer 20. The first trenches 31 expose the dielectric layer 30 at the top of the stack layer 201 located in the first regions 202, and the second trenches 32 expose the dielectric layer 30 at the top of the stack layer 201 located in the second regions 203. Here, the etching of the stop layer 20 may be performed by using, for example, a dry etching process. In a practical application, the etching process may be one of sputtering etching, chemical etching or high-density plasma etching, etc.

In some implementations of the present application, a process of etching the stop layer 20 is: taking the patterned first mask layer 10 as a mask to etch the stop layer 20, such that the first trenches 31 and the second trenches 32b with bottom opening sizes being greater than or equal to top opening sizes as shown in FIG. 6 can be formed, or the first trenches 31 and the second trenches 32a with the bottom opening sizes being smaller than to the top opening sizes as shown in FIG. 5 are formed.

In some implementations of the present application, since there is one stop layer 20 below the first mask layer 10, an etching time can be extended to make the bottom opening sizes of the first trenches 31 formed be greater than the top opening sizes, and to make the bottom opening sizes of the second trenches 32b formed be greater than the top opening sizes.

In a practical application, when etching the stop layer 20, the bottom opening sizes of the first trenches 31 and the top opening sizes of the second trenches 32 are broadened, thereby avoiding a footing effect (defects at the foot or bottom) due to the fact that an etching rate at the margin is less than an etching rate at the center for the first mask layer 10.

In examples of the present application, the patterned first mask 10 is taken as the mask for etching the stop layer 20, to form the second trenches 32b with the bottom opening sizes being greater than or equal to the top opening sizes. In a practical application, since there is one stop layer 20 below the first mask layer 10, the etching time can be extended to achieve an effect of broadening the bottom opening sizes of the second trenches 32b, so as to make the bottom opening sizes of the second trenches 32b formed within the first mask layer 10 be greater than or equal to the top opening sizes. In the present application, one stop layer 20 is added between the first mask layer 10 and the substrate, thereby avoiding the footing effect caused by too many byproducts generated by reactions of an etching gas with the dielectric layers 30 of the stack layer 201. Moreover, in the present application, when etching the first mask layer 10, the bottom opening sizes of the second trenches 32b are broadened, thereby avoiding the footing effect due to the fact that the etching rate at the margin is less than the etching rate at the center for the first mask layer 10.

In the examples of the present application, the etching of the stop layer 20 may be performed using, for example, a dry etching process or a wet etching process. In a practical application, an etching solution selected by the wet etching process may include a phosphoric acid solution which has a high etching selectivity ratio, and has a very high etching rate for the stop layer 20 (e.g., silicon nitride) while having an almost zero etching rate for the first mask layer 10 (e.g., silicon oxide).

In a practical application, for the case that the stop layer 20 is etched using the dry etching process, the opening sizes of the second trenches may be controlled by controlling the time of dry etching; and for the case that the stop layer 20 is etched using the wet etching process, the opening sizes of the second trenches may be controlled by controlling the time of wet etching and a concentration of the etching solution.

In some examples of the present application, before etching the stop layer 20 through the second trenches 32b, the patterned first mask layer 10 may be also removed, such that contaminants generated by etching gas bombardment on the first mask layer 10 in an etching process can be reduced.

Operation S220, etching the stack layer 201 within the first regions 202 through the first trenches 31 to form the plurality of channel holes 33.

Operation S230, etching the stack layer 201 within the second regions 203 through the second trenches 32 to form the plurality of first dummy channel holes 34.

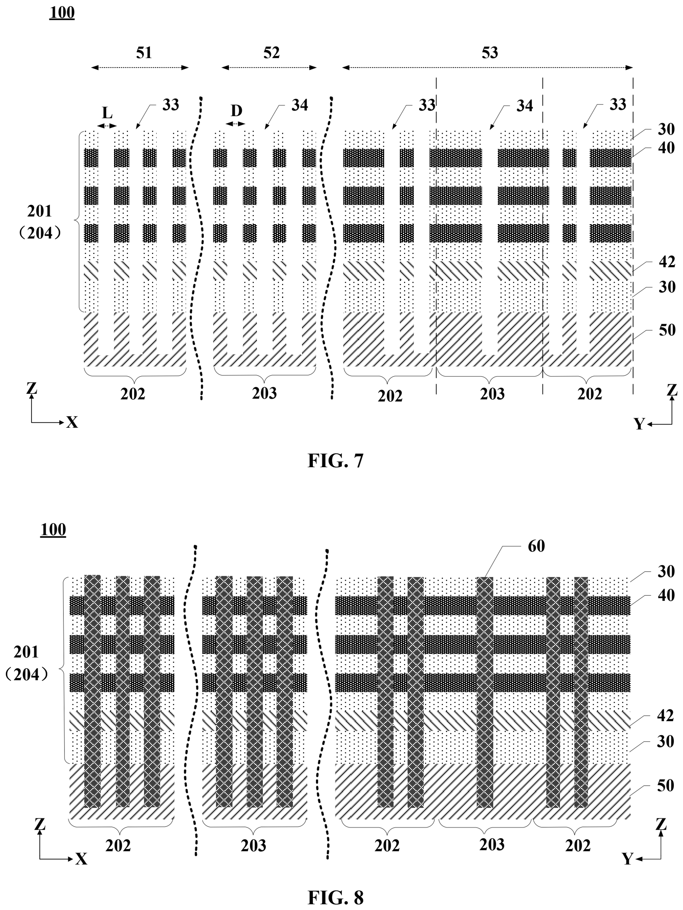

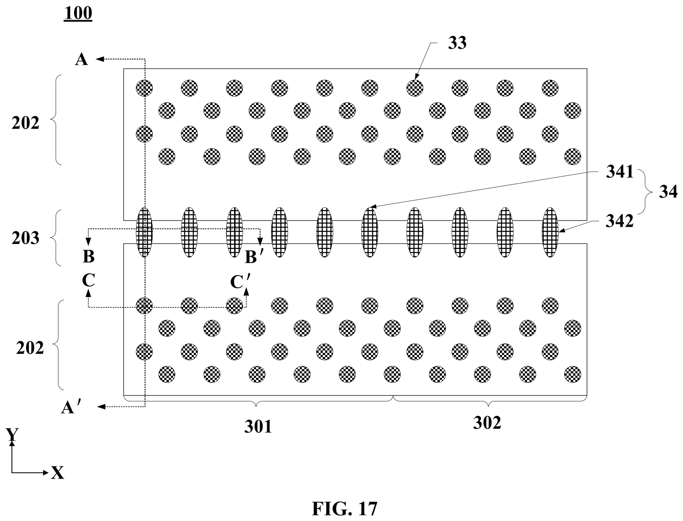

In some examples of the present application, referring to structures formed in operations S220 to S230 as shown in FIGs. 5 to 7 and FIGs. 17 to 22, the structure as shown in FIG. 7 comprises the substrate 50, the stack layer 201 disposed in the first direction (the Z axis direction), the plurality of first regions 202 disposed in the stack layer 201, and the second regions 203 each located between two of the first regions 202, wherein the first regions 202 comprise the plurality of channel holes 33 penetrating through the stack layer 201, and the second regions 203 comprise the plurality of first dummy channel holes 34 penetrating through the stack layer 201. A region 53 in FIG. 7 is a schematic sectional view of the semiconductor device 100 along an A-A' line in FIGs. 17 to 19, a region 52 in FIG. 7 is a schematic sectional view of the semiconductor device 100 along a B-B' line in FIGs. 17 to 19, and a region 51 in FIG. 7 is a schematic sectional view of the semiconductor device 100 along a C-C' line in FIGs. 17 to 19.

In some examples of the present application, the plurality of channel holes 33 penetrating through the stack layer 201 in the first regions 202 along the first direction (e.g., the Z axis direction) are formed using an etching process, and the plurality of first dummy channel holes 34 penetrating through the stack layer 201 in the second region 203 along the first direction (e.g., the Z axis direction) are also formed using the etching process. The etching process used by some examples of the present application may include dry etching or wet etching.

In some examples, the channel holes 33 may further extend into the substrate 50 but do not pass through the substrate 50, and the first dummy channel holes 34 may further extend into the substrate 50 but do not pass through the substrate 50.

In some implementations of the present application, the plurality of channel holes 33 may be arranged in an array.

In some examples, the plurality of channel holes 33 within the first regions 202 and the plurality of first dummy channel holes 34 within the second regions 203 may be formed in the same process, so as to form the plurality of channel holes 33 and the plurality of first dummy channel holes 34 in the first regions 202 and the second regions 203 at the same time.

In some implementations of the present application, the plurality of channel holes 33 and the plurality of first dummy channel holes 34 are alternately arranged in a misaligned manner in the second direction.

In some implementations of the present application, shapes of the first dummy channel holes 34 include, but are not limited to, any one of an ellipse or a circle, and shapes of the channel holes 33 include a circle. For example, as shown in FIGs. 17-20, the shapes of the first dummy channel holes 34 include an ellipse, and the major diameter of the ellipse is in the third direction (the Y axis direction).

In some alternative examples, the above-mentioned ellipse may also be substituted by a shape (such as an oval, a rectangle, a diamond, etc.) obtained by compressing a centrosymmetric shape (such as a circle or a square) in a certain direction or stretching the centrosymmetric shape to a certain scale.

In an example, as shown in FIG. 7, diameters of the first dummy channel holes 34 are represented as D, diameters of the channel holes 33 are represented as L, and the diameters D of the first dummy channel holes 34 and the diameters L of the channel holes 33 may be the same and may also be different.

In some examples, the number of layers of the stack layer 201 may be 8 layers, 32 layers, 64 layers, or 128 layers, etc. When the layers of the stack layer 201 are a small number, for example, 8 layers, the stack layer 201 may be directly formed by deposition, and then the channel holes 33 and the first dummy channel holes 34 are formed by one simultaneous etching. When the layers of the stack layer 201 are a large number, for example, 128 layers, the stack layer 201 may be split into a plurality of portions, and a first sub-stack layer 201 and a second sub-stack layer 201 are formed by two deposition processes, wherein the first sub-stack layer 201 is located above the second sub-stack layer 201. At this point, the channel holes 33 and the first dummy channel holes 34 are also formed by two times of etching, i.e., the channel holes 33 and the first dummy channel holes 34 are formed in the first sub-stack layer 201 and the second sub-stack layer 201 sequentially.

In addition, it is to be noted that, dotted lines in the figure are to distinguish different structure portions, and do not represent that the dotted lines actually exist. Dotted arrows in the figure are to identify distances or sizes between two portions, and do not represent that a connection relationship actually exists.

For example, in some examples of the present application, before forming the channel holes 33 penetrating through the stack layer 201 in the first regions 202 and forming the first dummy channel holes 34 penetrating through the stack layer 201 in the second regions 203, the patterned first mask layer 10 is formed on the top surface of the stack layer 201, so as to form the first trenches 31 and the second trenches 32 through the patterned first mask layer 10. Vertical projections of the first trenches 31 on top of the stack layer 201 may at least substantially overlap positions of the channel holes 33, and vertical projections of the second trenches 32 on top of the stack layer 201 may at least substantially overlap positions of the first dummy channel holes 34.

For example, a suitable etching process performed through the first mask layer 10 may be dry etching or wet etching to remove part of the dielectric layers 30 and the sacrificial layers 40 of the stack layer 201 in the first regions 202 exposed by the first trenches 31 to form the channel holes 33 as shown in FIG. 7, until the substrate 50 is exposed by the channel holes 33 formed by etching. In addition, part of the dielectric layers 30 and the sacrificial layers 40 of the stack layer 201 in the second regions 203 exposed by the second trenches 32 is removed to form the first dummy channel holes 34 as shown in FIG. 7, until the substrate 50 is exposed by the first dummy channel holes 34 formed by etching. In other words, the channel holes 33 and the first dummy channel holes 34 extend from a surface of the stack layer 201 facing away from the substrate 50 to the stack surface of the substrate 50 to expose the substrate 50, and a part of the channel holes 33 and the first dummy channel holes 34 is located in the substrate 50 but does not penetrate the substrate 50. After forming the channel holes 33 and the first dummy channel holes 34, the first mask layer 10 may be removed.

It is to be noted that, the plurality of channel holes 33 and the first dummy channel holes 34 may be formed in the stack layer 201 at the same time, that is, the first mask layer 10 may form the plurality of first trenches 31 corresponding to the plurality of channel holes 33 respectively, and the plurality of second trenches 32 corresponding to the plurality of first dummy channel holes 34. Positions of the plurality of first trenches 31 respectively correspond to positions of the plurality of channel holes 33 formed subsequently, and positions of the plurality of second trenches 32 respectively correspond to positions of the plurality of first dummy channel holes 34 formed subsequently. In some examples of the present application, no specific limitation is imposed on the number, sizes and arrangement manner of the channel holes 33 and the first dummy channel holes 34. That is, the channel holes 33 and the first dummy channel holes 34 as shown in FIGs. 7, and 17 to 26, are only examples, and are not used to limit the positions and the number of the channel holes 33 and the first dummy channel holes 34.

In some examples of the present application, the first dummy channel holes 34 penetrating through the stack layer 201 along the first direction (e.g., the Z axis direction) are formed using, for example, a dry/wet etching process, and the first dummy channel holes 34 may further extend into the substrate 50. A formation process of the first dummy channel holes 34 may be essentially the same as a formation process of the channel holes 33, that is, the first dummy channel holes 34 may be regarded as the channel holes 33 in the examples of the present application, except that the first dummy channel holes 34 in the second regions 203 are not used to form channel structures 330 but are used to form gate line slit trenches 101 for isolating the plurality of channel structures 330.

In some examples of the present application, when etching the stack layer 201 in the first regions 202 to form the channel holes 33, the first dummy channel holes 34 are formed by etching the stack layer 201 in the second regions 203 through the same process, thereby achieving one-time formation of the channel holes 33 of the first regions 202 and the first dummy channel holes 34 of the second regions 203 by etching. Subsequently, through a series of processes, the channel structures 330 are formed in the channel holes 33 of the first regions 202, and gate line isolation structures 102 are formed in the first dummy channel holes 34 of the second regions 203. The fabrication cost of the semiconductor device 100 fabricated according to some examples of the present application is low, and the problem of the yield loss caused by the tilting between the channel structures 330 and the gate line isolation structure 102 is solved.

Operation S300, forming the plurality of channel structures 330 in the plurality of channel holes 33.

In some implementations of the present application, before the operation S300 forming the plurality of channel structures 330 in the plurality of channel holes 33, the fabrication method further comprises:

operation S250, filling a sacrificial material 60 in the channel holes 33 and the first dummy channel holes 34.

In some examples of the present application, FIG. 8 shows a structure formed by operation S250. The structure as shown in FIG. 8 comprises the substrate 50, the stack layer 201 disposed in the first direction (the Z axis direction), the plurality of first regions 202 disposed in the stack layer 201, and the second regions 203 each located between two of the first regions 202, wherein the first regions 202 comprise the plurality of channel holes 33 penetrating through the stack layer 201, the second regions 203 comprise the plurality of first dummy channel holes 34 penetrating through the stack layer 201, and the plurality of channel holes 33 and the plurality of first dummy channel holes 34 are all filled with the sacrificial material 60.

Operation S270, removing the sacrificial material 60 in the channel holes 33.

In some implementations of the present application, after the operation S250 filling the sacrificial material 60 in the channel holes 33 and the first dummy channel holes 34 and before the operation S270 removing the sacrificial material 60 in the channel holes 33, the fabrication method further comprises:

operation S260, forming a cap layer 71 on top of the stack layer 201 and removing the cap layer 71 above the channel holes 33.

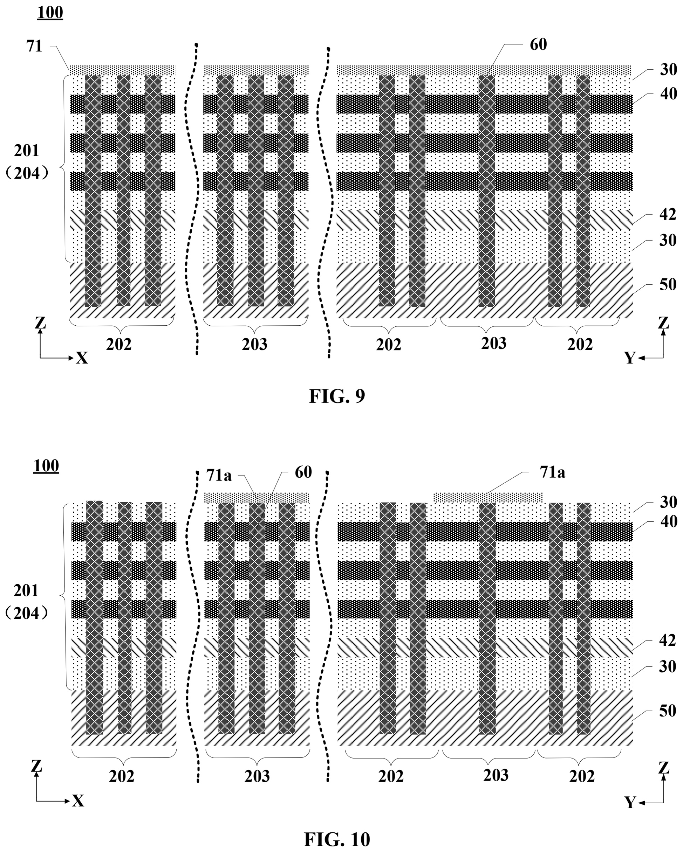

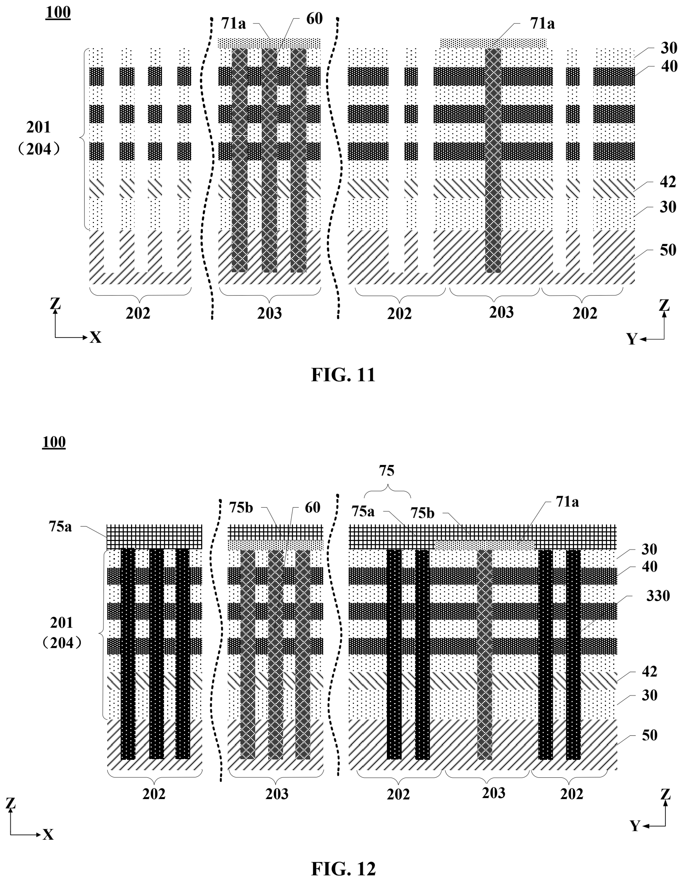

In some examples of the present application, FIGs. 9 to 11 show structures formed by operations S260 to S270. The structure as shown in FIG. 9 comprises the substrate 50, the stack layer 201 disposed in the first direction (the Z axis direction), the plurality of first regions 202 disposed in the stack layer 201, and the second regions 203 each located between two of the first regions 202. The first regions 202 comprise the plurality of channel holes 33 penetrating through the stack layer 201. The second regions 203 comprise the plurality of first dummy channel holes 34 penetrating through the stack layer 201. The channel holes 33 and the first dummy channel holes 34 are all filled with the sacrificial material 60, and the cap layer 71 is further disposed above the stack layer 201 and covers the channel holes 33 filled with the sacrificial material 60 and the first dummy channel holes 34 filled with the sacrificial material 60. FIG. 10 shows the structure formed by the operation S260. As compared with the structure as shown in FIG. 9, in the structure as shown in FIG. 10, the cap layer 71 above the channel holes 33 is removed. As compared with the structure as shown in FIG. 10, in the structure as shown in FIG. 11, the sacrificial material 60 filled in the channel holes 33 as shown in FIG. 8 is removed, the sacrificial material 60 is filled in the first dummy channel holes 34, and the cap layer 71a is disposed above the first dummy channel holes 34.

In some implementations, the cap layer 71 is formed on a side of the stack layer 201 far away from the substrate 50 using a thin film deposition process to cover the top of the stack layer 201. The cap layer 71 may be fabricated by using a dielectric material, such as silicon oxide.

As shown in FIG. 8, the sacrificial material 60 may be filled in the channel holes 33 and the first dummy channel holes 34 as shown in FIG. 7 through a deposition process, and then the cap layer 71 as shown in FIG. 9 is formed on top of the stack layer 201 through a deposition process. As shown in FIG. 10, part of the cap layer 71 above the channel holes 33 is removed by an etching process, and the cap layer 71a above the first dummy channel holes 34 is remained. The cap layer 71a covers the first dummy channel holes 34, and projections of the cap layer 71a and the channel holes 33 on the substrate 50 do not overlap, that is, the cap layer 71a as shown in FIG. 10 covers the first dummy channel holes 34 and does not cover the channel holes 33. The material of the cap layer 71a is different from the sacrificial material 60. The sacrificial material 60 in the channel holes 33 may be removed using an etching process to obtain the semiconductor structure as shown in FIG. 11.

In some examples, the sacrificial material 60 may include, but not be limited to, a combination of any of one or more of carbon, polysilicon, silicon nitride, silicon oxide and aluminum oxide. The sacrificial material 60 in this example may include carbon or polysilicon, etc.

In some implementations, both the channel holes 33 and the first dummy channel holes 34 may further extend into the substrate 50 but do not pass through the substrate 50.

In addition, it is to be noted that, after removing the sacrificial material 60 in the channel holes 33, the cap layer 71a above the first dummy channel holes 34 may be removed.

In some examples of the present application, FIG. 12 shows a structure formed by the operation S300. The structure as shown in FIG. 12 comprises the substrate 50, the stack layer 201 disposed in the first direction (the Z axis direction), the plurality of first regions 202 disposed in the stack layer 201, and the second regions 203 each located between two of the first regions 202. The first regions 202 comprise the plurality of channel structures 330 penetrating through the stack layer 201. The second regions 203 comprise the plurality of first dummy channel holes 34 penetrating through the stack layer 201. The first dummy channel holes 34 are filled with the sacrificial material 60. The cap layer 71a is disposed above the first dummy channel holes 34. A conductive layer 75 covers the top of the stack layer 201, that is, a conductive layer 75a as shown in FIG. 12 covers the channel structures 330, and a conductive layer 75b covers the cap layer 71a above the first dummy channel holes 34 filled with the sacrificial material 60.

In a practical application, as shown in FIG. 12, the conductive layer 75 is deposited above the cap layer 71a and the channel structures 330 through a deposition process, and a deposition rate of the conductive layer 75b deposited above the cap layer 71a is less than a deposition rate of the conductive layer 75a deposited above the channel structures 330, such that a thickness of the conductive layer 75b deposited above the cap layer 71a along the first direction is less than a thickness of the conductive layer 75a deposited above the channel structures 330 along the first direction.

In some examples, the conductive layer 75 may include, but not be limited to, ruthenium (Ru), iridium (Ir), tungsten (W), tantalum (Ta), copper (Cu), aluminum (Al), doped silicon, silicide or a combination of any of one or more of the above materials.

In an example, the channel structures 330 may be formed by deposition in the channel holes 33 through multiple deposition processes. In some examples, the channel structures 330 comprise a poly channel layer and a channel layer, that is, the poly channel layer and the channel layer may be deposited in the channel holes 33 sequentially through the multiple deposition processes to form the channel structures 330 having a storage function. The poly channel layer in the channel structures 330 is a critical structure of the three-dimensional memory to achieve the storage function. In an example, the poly channel layer comprises a silicon oxide/silicon nitride/silicon oxide (ONO) structure sequentially formed on outer walls of the channel structures 330, that is to say, there is the poly channel layer having the silicon oxide/silicon nitride/silicon oxide (ONO) structure sequentially formed from outside to inside along a radial direction on sidewalls of the channel structures 330, and each gate line layer 41 may be in contact with the corresponding poly channel layer of the ONO structure, thereby forming a plurality of memory cells. In each memory cell, the gate line layers 41 may be in contact with the corresponding poly channel layer of the ONO structure, and can control the corresponding ONO structure to achieve the storage function by means of trapping charges. The poly channel layer of the ONO structure comprises a blocking layer, a charge trapping layer and a tunneling layer. Further, the blocking layer, the charge trapping layer, the tunneling layer and the channel layer may be sequentially deposited on inner walls of the channel holes 33 using a thin film deposition process, such as CVD, PVD, ALD or any combination thereof.

The blocking layer may be formed on surfaces of the inner walls of the channel holes 33, and is configured to prevent charge (electrons or holes) stored in the charge trapping layer from outflowing and to provide electrical isolation between the charge trapping layer and a stack structure 204. In an example, the material of the blocking layer may include, but not be limited to silicon oxide ($SiO_2$) and a high k dielectric. In some examples, the material of the blocking layer may include the high k dielectric. The high k dielectric material has a thinner equivalent oxide thickness (EOT), which can effectively reduce gate leakage while maintaining the transistor performance. The high k dielectric may include, for example, aluminum oxide, hafnium oxide, or zirconium oxide, or the like. The blocking layer may be a single-layer dielectric oxide, and may also be a multi-layer model, such as a high k oxide and silicon oxide, etc.

The charge trapping layer may be formed on an inner surface of the blocking layer. In an example, the material of the charge trapping layer may include, but not be limited to, silicon nitride (SiN). In another example, the charge trapping layer may be a multi-layer structure, e.g., a multi-layer structure of SiN/SiON/SiN.

The tunneling layer may be formed on a surface of the charge trapping layer. In an example, the material of the tunneling layer may include, but not be limited to, silicon oxide ($SiO_2$). In some examples, the tunneling layer may also be a multi-layer structure, e.g., a multi-layer structure of $SiO/SiON/SiO_2$.

The blocking layer, the charge trapping layer and the tunneling layer above may be referred to as the poly channel layer. It should be understood that, the poly channel layer may be a memory structure of the fabricated three-dimensional memory, and portions in the poly channel layer corresponding to various gate line layers 41 may form independent memory cells. Each memory cell may be controlled by the gate line layers 41. The charges are stored into or released from the poly channel layer corresponding to the gate line layers 41, so as to achieve functions of the individual memory cells.

The channel layer may be formed on a surface of the tunneling layer. In an example, the material of the channel layer includes, but is not limited to, doped polysilicon.

It should be noted that, in some examples of the present application, the plurality of channel structures 330 penetrating through the stack layer 201 and extending to the substrate 50 may be formed. The number and arrangement of the channel structures 330 may be set according to actual storage requirements, and the number and the arrangement of the channel structures 330 as shown in the figure are only examples, and do not represent the number and the arrangement of the channel structures 330 of the final semiconductor structure.

Operation S400, forming the gate line slit trenches 101 that extend in the second direction (e.g., the X axis direction) and surround the plurality of first dummy channel holes 34, wherein the second direction intersects the first direction.

In some implementations of the present application, before the operation S400 forming the gate line slit trenches 101 that extend in the second direction (e.g., the X axis direction) and surround the plurality of first dummy channel holes 34, the fabrication method further comprises:

operation S350, removing the sacrificial material 60 in the first dummy channel holes 34.

In some implementations of the present application, after the operation S300 forming the plurality of channel structures 330 in the plurality of channel holes 33 and before the operation S350 removing the sacrificial layer 40 in the first dummy channel holes 34, the fabrication method further comprises:
operation S310, forming a protective layer 80 on top of the stack layer 201.

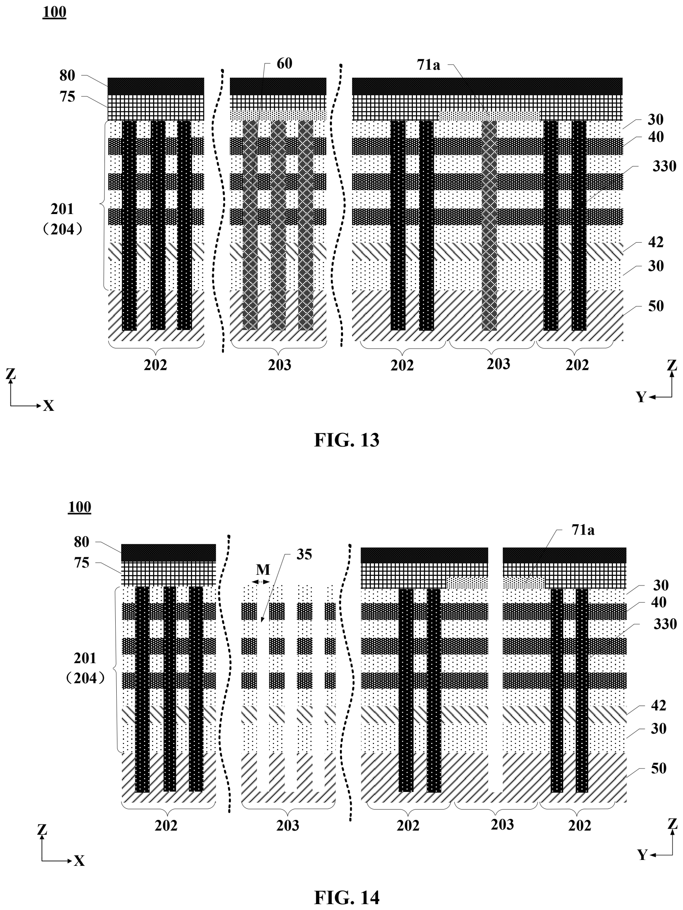

In some examples of the present application, FIG. 13 shows a structure formed by the operation S310. The structure as shown in FIG. 13 comprises the substrate 50, the stack layer 201 disposed in the first direction (the Z axis direction), the plurality of first regions 202 disposed in the stack layer 201, and the second regions 203 each located between two of the first regions 202. The first regions 202 comprise the plurality of channel structures 330 penetrating through the stack layer 201, such as the channel structures 330 of the ONO structure formed with reference to the example corresponding to the operation S300 above. The second regions 203 comprise the plurality of first dummy channel holes 34 penetrating through the stack layer 201. The first dummy channel holes 34 are filled with the sacrificial material 60. The cap layer 71a is disposed above the first dummy channel holes 34. The conductive layer 75 covers the top of the stack layer 201. In addition, the protective layer 80 is disposed above the conductive layer 75.

In a practical application, the protective layer 80 is deposited above the conductive layer 75 through a deposition process, and may include a combination of any of one or more of carbon, polysilicon, silicon nitride, silicon oxide and aluminum oxide. In an example of the present application, the protective layer 80 includes polysilicon.

In some examples of the present application, FIG. 14 shows a structure formed by the operation S350. The structure as shown in FIG. 14 comprises the substrate 50, the stack layer 201 disposed in the first direction (the Z axis direction), the plurality of first regions 202 disposed in the stack layer 201, and the second regions 203 each located between two of the first regions 202. The first regions 202 comprise the plurality of channel structures 330 penetrating through the stack layer 201. The second regions 203 comprise the plurality of first dummy channel holes 34 penetrating through the stack layer 201. The cap layer 71a is disposed above the dielectric layer 30 at the top of the stack layer 201 on two sides of the first dummy channel holes 34. The conductive layer 75 is disposed above the channel structures 330. The protective layer 80 is disposed above the conductive layer 75. In a practical application, the sacrificial material 60 filled in the first dummy channel holes 34 of the second regions 203 is removed by an etching process.

In some implementations of the present application, operation S400 forming the gate line slit trenches 101 that extend in the second direction (e.g., the X axis direction) and surround the plurality of first dummy channel holes 34 comprises:
operation S410, etching the plurality of first dummy channel holes 34 to form a plurality of second dummy channel holes 35, and connecting the plurality of second dummy channel holes 35 together in the second direction to form the gate line slit trenches 101.

In some examples of the present application, FIG. 14 shows a structure comprising the plurality of second dummy channel holes 35 formed in the operation S410. The structure as shown in FIG. 14 comprises the substrate 50, the stack layer 201 disposed in the first direction (the Z axis direction), the plurality of first regions 202 disposed in the stack layer 201, and the second regions 203 each located between two of the first regions 202, wherein the first regions 202 comprise the plurality of channel structures 330 penetrating through the stack layer 201, the conductive layer 75 is disposed above the channel structures 330, and the protective layer 80 is disposed above the conductive layer 75. The second regions 203 comprise the plurality of second dummy channel holes 35 penetrating through the stack layer 201.

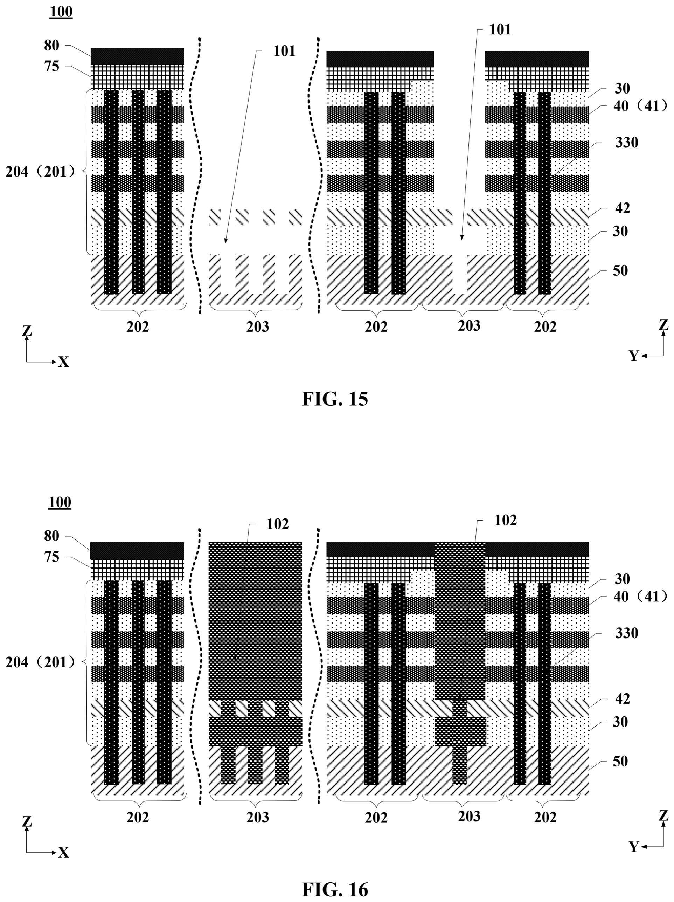

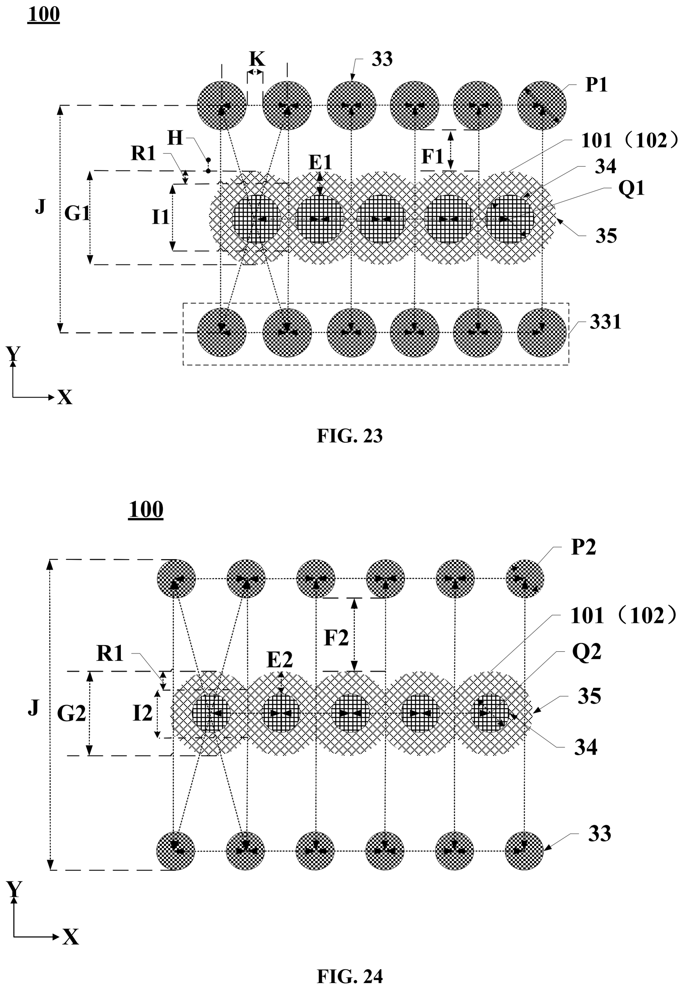

In some examples of the present application, FIGs. 15 and 23 to 26 show a structure comprising the gate line slit trenches 101 formed in the operation S410. The structure as shown in FIGs. 15 and 23 to 26 comprises the substrate 50, the stack layer 201 disposed in the first direction (the Z axis direction), the plurality of first regions 202 disposed in the stack layer 201, and the second regions 203 each located between two of the first regions 202, wherein the first regions 202 comprise the plurality of channel structures 330 penetrating through the stack layer 201, the conductive layer 75 is disposed above the channel structures 330, and the protective layer 80 is disposed above the conductive layer 75. The second regions 203 comprise the plurality of gate line slit trenches 101 penetrating through the stack layer 201, wherein the gate line slit trenches 101 extend along the second direction and surround the plurality of second dummy channel holes 35 as shown in FIGs. 23 and 24.

In the present application, isotropic etching may be performed on the plurality of first dummy channel holes 34 as shown in FIG. 13 through an etching process to enlarge the diameters of the plurality of first dummy channel holes 34, thereby forming the plurality of second dummy channel holes 35 as shown in FIGs. 23 and 24. A process of forming the second dummy channel holes 35 in the present application may include sequentially penetrating the protective layer 80 and the conductive layer 75 deposited on top of the stack layer 201 of the second regions 203 through a dry etching process, and then forming the plurality of second dummy channel holes 35 through a wet etching process, wherein the second dummy channel holes 35 penetrate through the stack layer 201 in the second regions 203 along the first direction (the Z axis direction), and diameters of the second dummy channel holes 35 are greater than or equal to the diameters of the first dummy channel holes 34, such that the plurality of second dummy channel holes 35 extend along the second direction, and two adjacent ones of the second dummy channel holes 35 are partially interleaved or partially overlapped along the second direction, so as to form the gate line slit trenches 101 that connect together and surround the plurality of first dummy channel holes 34 along the second direction.

In an example, as shown in FIGs. 7 and 14, the diameters of the second dummy channel holes 35 are represented as M, the diameters of the first dummy channel holes 34 are represented as D, the diameters of the channel holes 33 are represented as L, and the diameters M of the second dummy channel holes 35 are greater than or equal to the diameters D of the first dummy channel holes 34, i.e., M ≥ D.

For example, in some examples of the present application, before forming the second dummy channel holes 35 penetrating through the stack layer 201 in the second regions 203, a patterned second mask layer (not shown in the figures) is formed on the top surface of the stack layer 201. Third trenches (not shown in the figures) corresponding to the second dummy channel holes 35 are formed in the patterned second mask layer, and vertical projections of the third trenches on top of the stack layer 201 may at least substantially overlap the positions of the second dummy channel holes 35. By disposing the second mask layer, etching positions of the second dummy channel holes 35 can be determined quickly and accurately.

After exposing the etching positions of the second dummy channel holes 35, a suitable etching process which, for example, may be dry etching or wet etching, may be performed to remove part of the dielectric layers 30 and the sacrificial layers 40 of the stack layer 201 in the second regions 203 exposed by the third trenches, so as to form the second dummy channel holes 35 as shown in FIGs. 14, 23 and 24, until the substrate 50 is exposed by the first dummy channel holes 34 formed by etching, such that the plurality of second dummy channel holes 35 extend along the second direction, and two adjacent ones of the second dummy channel holes 35 are partially interleaved or partially overlapped along the second direction, so as to form the gate line slit trenches 101 that connect together and surround the plurality of first dummy channel holes 34 along the second direction. The second dummy channel holes 35 extend from the surface of the stack layer 201 facing away from the substrate 50 to the stack surface of the substrate 50 to expose the substrate 50, and a part of the second dummy channel holes 35 is located in the substrate 50 but does not penetrate the substrate 50. After forming the second dummy channel holes 35, the second mask layer may be removed.

In some examples, the shapes of the second dummy channel holes 35 include any one of an ellipse or a circle. In some alternative examples, the above ellipse may also be substituted by other shapes (such as an oval, a rectangle, a diamond, etc.) that can be obtained by compressing a centrosymmetric shape (such as a circle or a square) in a certain direction or stretching the centrosymmetric shape to a certain scale.

Operation S500, forming the gate line isolation structures 102 in the gate line slit trenches 101, wherein the gate line isolation structures 102 are in a concavo-convex shape along the third direction that intersects the first direction and the second direction.

In some examples of the present application, FIGs. 16 and 23 to 26 show a structure formed by the operation S500. The formed structure comprises the substrate 50, the stack layer 201 disposed in the first direction (the Z axis direction), the plurality of first regions 202 disposed in the stack layer 201, and the second regions 203 each located between two of the first regions 202, wherein the first regions 202 comprise the plurality of channel structures 330 penetrating through the stack layer 201, the conductive layer 75 is disposed above the channel structures 330, and the protective layer 80 is disposed above the conductive layer 75. The second regions 203 comprise the plurality of gate line slit trenches 101 penetrating through the stack layer 201.

In the present application, a conductive material may be filled in the plurality of gate line slit trenches 101 as shown in FIG. 15 through a deposition process, thereby forming the plurality of gate line isolation structures 102 of the second regions 203 as shown in FIGs. 16, and 23 to 26. The gate line isolation structures 102 penetrate through the stack structure 204 along the first direction and extend along the second direction, and the gate line isolation structures 102 are in a concavo-convex shape along the second direction.

In some implementations, the conductive material may include ruthenium (Ru), iridium (Ir), tungsten (W), tantalum (Ta), copper (Cu), aluminum (Al), doped silicon, silicide or a combination of any of one or more of the above materials.

It should be understood that, in the present application, the plurality of gate line isolation structures 102 that penetrate through the stack structure 204 and extend to the substrate 50 but do not pass through the substrate 50 may be formed, wherein the plurality of gate line isolation structures 102 and the plurality of channel structures 330 are spaced apart and interleaved in the third direction (e.g., the Y axis direction), so as to separate the plurality of channel structures 330 through the gate line isolation structures 102. The number and arrangement of the gate line isolation structures 102 in the examples of the present application may be set according to actual storage requirements.

In some implementations of the present application, before the operation S500 forming the gate line isolation structures 102 in the gate line slit trenches 101, the fabrication method further comprises: replacing the sacrificial layers 40 in the stack layer 201 with the gate line layers 41.

In some examples of the present application, both the stack structure 204 in the first regions 202 and the stack structure 204 in the second regions 203 comprise the dielectric layers 30 and the gate line layers 41 stacked alternately. It may be understood that, at the time when they are just formed, both the stack structure 204 in the first regions 202 and the stack structure 204 in the second regions 203 comprise the stack layer 201 including the dielectric layers 30 and the sacrificial layers 40 stacked alternately, and the dielectric layers 40 are replaced by the gate line layers 41 in a subsequent process so as to obtain the stack structure 204.

In some examples of the present application, the material of the gate line layers 41 may include ruthenium (Ru), iridium (Ir), tungsten (W), tantalum (Ta), copper (Cu), aluminum (Al), doped silicon, silicide or a combination of any of one or more of the above materials. The gate line layers 41 may include metal tungsten in the present application.

In some implementations of the present application, the stack layer 201 comprises a core area 301 and a stair step area 302;

the plurality of first dummy channel holes 34 with equal diameters along the third direction are formed in the core area 301 and the stair step area 302.

In some examples of the present application, the semiconductor device 100 may have the core area, the stair step area 302 and a periphery area (not shown in the figures). The core area 301 is a region for forming the memory cell, the stair step area 302 is a region for forming a word line connection circuit, and the periphery area is a region for forming a periphery circuit. Adjacent ones of the first regions 202 are separated by the gate line isolation structures 102 that may extend through the core area 301 and the stair step area 302.

Referring to FIG. 17, the plurality of first dummy channel holes 34 arranged alternately along the second direction are disposed in both the core area 301 and the stair step area 302 of the stack layer 201, and penetrate through the stack layer 201 along the first direction in this example. The plurality of first dummy channel holes 34 with the equal diameters along the third direction are formed in the core area 301. In addition, the plurality of first dummy channel holes 34 with the equal diameters along the third direction are formed in the stair step area 302, and a size of each first dummy channel hole 34 in the core area 301 along the third direction is the same as a size of each first dummy channel hole 34 in the stair step area 302 along the third direction. A process flow of forming the plurality of first dummy channel holes 34 in the stack layer 201 may refer to the examples corresponding to the operation S230 above, which are no longer repeated here.

In some implementations of the present application, the stack layer 201 comprises a core area 301 and a stair step area 302;

the diameters of the plurality of first dummy channel holes 34 formed in the core area 301 along the third direction are smaller than the diameters of the plurality of first dummy channel holes 34 formed in the stair step area 302 along the third direction.

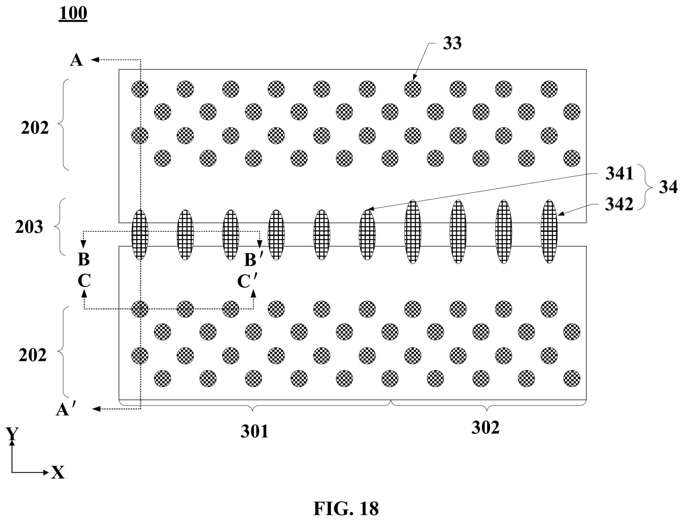

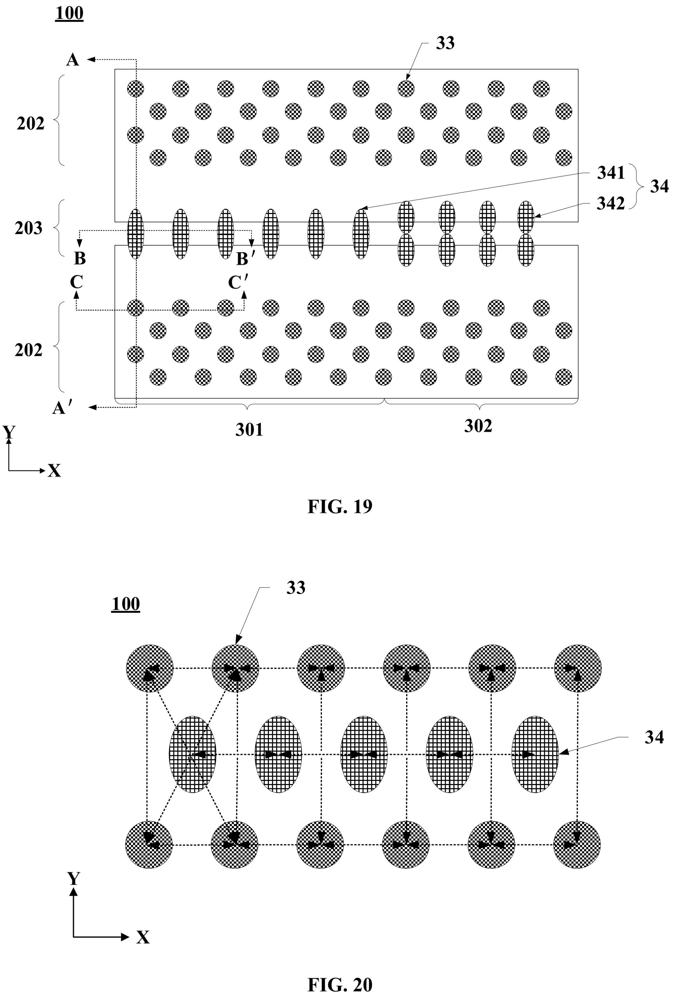

In some examples of the present application, referring to FIGs. 18 and 19, the plurality of first dummy channel holes 34 arranged alternately along the second direction are disposed in both the core area 301 and the stair step area 302 of the stack layer 201, and penetrate through the stack layer 201 along the first direction in this example. The plurality of first dummy channel holes 34 with the equal diameters along the third direction are formed in the core area 301. In addition, the plurality of first dummy channel holes 34 with the equal diameters along the third direction are formed in the stair step area 302, and the size of each first dummy channel hole 34 in the core area 301 along the third direction is smaller than the size of each first dummy channel hole 34 in the stair step area 302 along the third direction. A process flow of forming the plurality of first dummy channel holes 34 in the stack layer 201 may refer to the examples corresponding to the operation S230 above, which are no longer repeated here.

Referring to FIG. 18, the size of each of the first dummy channel holes 34 in the core area 301 along the third direction is smaller than the size of each of the first dummy channel holes 34 in the stair step area 302 along the third direction.

Referring to FIG. 19, the size of each of the first dummy channel holes 34 in the core area 301 along the third direction is smaller than a total size, along the third direction, of the ones of the plurality of first dummy channel holes 34 connected in parallel in the third direction in the stair step area 302, that is a sum of the sizes of the plurality of first dummy channel holes 34 along the third direction.

In some examples, the first dummy channel holes 34 in the core area 301 and the first dummy channel holes 34 in the stair step area 302 may be formed in the same process, so as to achieve the objective of forming the first dummy channel holes 34 in the core area 301 and the stair step area 302 at the same time without additional cost. In some examples, the first dummy channel holes 34 may penetrate through the stack layer 201 and extend into the substrate 50 but do not pass through the substrate 50.

The stair step area 302 may be located on two sides of the core area 301, or the core area 301 may be located on two sides of the stair step area 302, which is not specifically defined.

In the present application, when etching the stack layer 201 in the first regions 202 to form the channel holes 33, the first dummy channel holes 34 are formed by etching the stack layer 201 in the second regions 203 through the same process, thereby achieving one-time formation of the channel holes 33 of the first regions 202 and the first dummy channel holes 34 of the second regions 203 by etching. Subsequently, through a series of processes, the channel structures 330 are formed using the channel holes 33 of the first regions 202, and the gate line isolation structures 102 are formed using the first dummy channel holes 34 of the second regions 203. The fabrication cost of the semiconductor device 100 of the present application is low, and the problem of the yield loss caused by the tilting between the channel structures 330 and the gate line isolation structures 102 is solved.

A layout design of a first mask of the present application is as shown in FIG. 17. The channel structures 330 achieving the storage function may be formed within the channel holes 33 in FIG. 17. The first dummy channel holes 34 in FIG. 17 are for forming the gate line slit trenches 101. In the present application, while forming the channel holes 33 in the first regions 202 by etching, the first dummy channel holes 34 in the second regions 203 are formed by etching, which can reduce one etching operation from the overall processes, thereby lowering the fabrication cost of the device significantly.

In the examples of the present application, the gate line slit trenches 101 are formed in the first dummy channel holes 34 formed simultaneously with the channel holes 33, such that tilting degrees of the formed channel holes 33 and the formed first dummy channel holes 34 substantially keep consistent, thereby effectively avoiding the yield loss caused by the mutual tilting between the channel holes 33 and the first dummy channel holes 34. Moreover, since the channel holes 33 and the first dummy channel holes 34 are formed simultaneously, the function of the first dummy channel holes 34 is equivalent to the function of gate line slit holes. As such, a process step of forming the gate line slit holes subsequently is omitted, and the process cost is lowered effectively. In addition, the channel holes 33 and the first dummy channel holes 34 are formed simultaneously, and the gate line isolation structures 102 are formed through the first dummy channel holes 34 of the second regions 203, so that the problem of the mutual tilting between the channel structures 330 of the first regions 202 and the gate line isolation structures 102 of the second regions 203 is solved.

In an example, as shown in FIGs. 4 to 16, first, the stack layer 201 is formed by deposition, and comprises the dielectric layers 30 and the sacrificial layers 40, wherein the dielectric layers 30 may include SIN, and the sacrificial layers 40 may include SiO. Then, the first mask layer 10 (e.g., the hard mask layer or the photoresist layer) is formed on top of the stack layer 201. Photolithographic patterning is performed through the first mask layer 10, and at the same time, openings are formed in the first regions 202 and the second regions 203 to form the first trenches 31 and the second trenches 32 respectively. The plurality of channel holes 33 are formed in the first regions 202 through the plurality of first trenches 31, and the plurality of first dummy channel holes 34 are formed in the second regions 203 through the plurality of second trenches 32. The sacrificial material 60 is filled in the channel holes 33 and the first dummy channel holes 34 respectively, and then a cap oxide is filled. Next, the cap oxide formed on the top of the channel holes 33 of the first regions 202 and the sacrificial material 60 filled in the channel holes 33 are removed sequentially. Next, the channel structures 330 are formed in the channel holes 33, and the protective layer 80 is formed on the stack layer 201, wherein the material of the protective layer 80 may include polysilicon. Next, the protective layer 80 formed on top of the stack layer 201 of the second regions 203 is removed, then the sacrificial material 60 previously filled in the first dummy channel holes 34 is removed, and the stack layer 201 of the second regions 203 is removed through the first dummy channel holes 34 using a wet etching process to form the gate line slit trenches 101 in a concavo-convex shape along the second direction. Next, the sacrificial layers 40 of the stack layer 201 are replaced by the gate line layers 41 to obtain the stack structure 204. Finally, the gate line isolation structures 102 are formed in the gate line slit trenches 101.

A layout design of the first mask layer 10 of the present application is as shown in FIGs. 17 to 19. In some implementations, the shapes and the sizes of the first dummy channel holes 34 in the second regions 203 may be set freely, as long as the first dummy channel holes 34 in the second regions 203 and the channel holes 33 in the first regions 202 are formed in the same process, such that the gate line isolation structures 102 in the concavo-convex shape along the second direction may be formed through the first dummy channel holes 34.

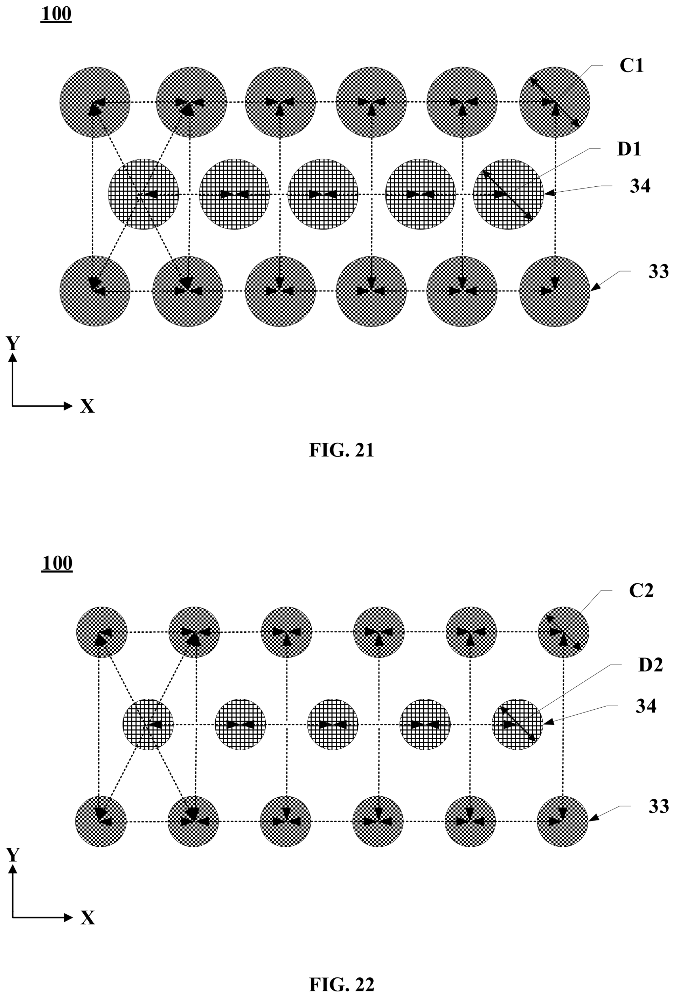

The first dummy channel holes 34 in the examples of the present application may have variations in size and shape, so that the gate line slit trenches 101 as shown in FIGs. 23 to 26 are formed through the first dummy channel holes 34 with their respective sizes and shapes. In an example, FIG. 20 shows a top view (i.e., ADI TOP View) of opening sizes after development inspection (ADI) of the first dummy channel holes 34 and the channel holes 33 on top of the stack layer 201 along the X axis direction and the Y axis direction. In FIG. 20, the shapes of an upper row and a lower row of the channel holes 33 along the Y axis direction are circular, and the first dummy channel holes 34 between the upper row and the lower row of the channel holes 33 are elliptical, with major axes of the ellipses along the Y axis direction and minor axes of the ellipses along the X axis direction. The first dummy channel holes 34 and the channel holes 33 as shown in FIGs. 21 and 22 are obtained by etching the stack layer 201 according to the layout design as shown in FIG. 20. FIG. 21 is a top view of opening sizes after etching inspection (AEI) (i.e., AEI TOP CD) of the first dummy channel holes 34 and the channel holes 33 on top of the stack layer 201 along the X axis direction and the Y axis direction. FIG. 22 is a bottom view of opening sizes after etching inspection (AEI) (i.e., AEI Bottom CD) of the first dummy channel holes 34 and the channel holes 33 on the bottom of the stack layer 201 along the X axis direction and the Y axis direction. As shown in FIGs. 21 and 22, the first dummy channel holes 34 and the channel holes 33 are formed by etching based on what is shown in FIG. 20, and the opening sizes of the first dummy channel holes 34 and the channel holes 33 on top of the stack layer 201 (i.e., a side of the stack layer 201 far away from the substrate 50) along the first direction and the second direction are greater than the opening sizes of the first dummy channel holes 34 and the channel holes 33 on the bottom of the stack layer 201 (i.e., a side of the stack layer 201 close to the substrate 50).

In the present application, a T/B (a top/bottom removal distance ratio) for etching by using a wet etching process is > 0.9, and a B/T (bottom/top, i.e., a ratio of the size of the bottom of the gate line slit trench 101 along the third direction to the size of the top of the gate line slit trench 101 along the third direction) of a resultant equivalent gate line slit trench 101 is about 0.83. A spacing distance between the formed gate line slit trench 101 and the adjacent channel structure 330 along the second direction is controlled by the duration of wet etching, and a sufficient process window needs to be reserved.

Table 1. The top removal distance and bottom removal distance of the gate line slit trenches 101 formed by wet etching

| Parameters | Descriptions | CD (size) |
|---|---|---|
| K (nm) | A distance between two adjacent ones of the channel holes 33 along the X axis direction | 150 |
| J (nm) | A distance between two adjacent ones of the channel holes 33 along the Y axis direction | 500 |
| P1 (nm) | A diameter of the channel holes 33 on the top of the stack layer 201 | 110 |
| P2 (nm) | A diameter of the channel holes 33 on the bottom of the stack layer 201 | 80 |
| Q1 (nm) | A diameter of the first dummy channel holes 34 on the top of the stack layer 201 | 110 |
| Q2 (nm) | A diameter of the first dummy channel holes 34 on the bottom of the stack layer 201 | 80 |
| E1 (nm) | A size, along the Y axis direction, of the tops of the gate line slit trenches 101 formed by removing the stack layer 201 around the first dummy channel holes 34 | 80 |
| E2 (nm) | A size, along the Y axis direction, of the bottoms of the gate line slit trenches 101 formed by removing the stack layer 201 around the first dummy channel holes 34 | 72 |
| F1 (nm) | A spacing distance between the top of the gate line slit trench 101 and the adjacent channel structure 330 along the Y axis direction | 60 |
| F2 (nm) | A spacing distance between the bottom of the gate line slit trench 101 and the adjacent channel structure 330 along the Y axis direction | 98 |
| G1 (nm) | A size of the tops of the gate line slit trenches 101 along the Y axis direction (i.e., a size of protrusions on the top of the gate line slit trenches 101 along the Y axis direction) | 270 |
| G2 (nm) | A size of the bottoms of the gate line slit trenches 101 along the Y axis direction (i.e., a size of protrusions on the bottom of the gate line slit trenches 101 along the Y axis direction) | 224 |
| H (nm) | A difference between a size of the gate line slit trenches 101 on the top of the stack layer 201 along the Y axis direction and a size of the gate line slit trenches 101 on the bottom of the stack layer 201 along the Y axis direction after etching | - |
| I1 (nm) | A maximum intersection size, along the Y axis direction, of the tops of the plurality of gate line slit trenches 101 arranged continuously and alternately along the X axis direction (i.e., a size of recesses on the tops of the gate line slit trenches 101 along the Y axis direction) | - |
| I2 (nm) | A maximum intersection size, along the Y axis direction, of the bottoms of the plurality of gate line slit trenches 101 arranged continuously and alternately along the X axis direction (i.e., a size of recesses on the bottoms of the gate line slit trenches 101 along the Y axis direction) | - |
| R1 (nm) | A difference, between the maximum intersection size, along the Y axis direction, of the tops of the plurality of gate line slit trenches 101 arranged continuously and alternately along the X axis direction and the size of the tops of the gate line slit trenches 101 along the Y axis direction | - |
| R2 (nm) | A difference, between the maximum intersection size, along the Y axis direction, of the bottoms of the plurality of gate line slit trenches 101 arranged continuously and alternately along the X axis direction and the size of the bottoms of the gate line slit trenches 101 along the Y axis direction | - |

F is equal to one half of a difference of J minus G and minus P. That is to say, the above parameters are in accordance with the following formula:

$$F = (J - G - P)/2$$

for example, F1=(J-G1-P1)/2, F2=(J-G2-P2)/2.

G is equal to a sum of Q and twice E. That is to say, the above parameters are in accordance with the following formula:

$$G = Q + 2E$$

for example, G1=Q1+2E1, G2=Q2+2E2.

G is equal to a sum of I and twice R. That is to say, the above parameters are in accordance with the following formula:

$$G = I + 2R$$

Generally, G is greater than I, for example, G1=I1+2R1, G2=I2+2R2, and both R1 and R2 are greater than zero.

H is equal to a difference of one half of G minus one half of a square root value, and the square root value is a square root of a difference of a square of G minus a square of K. That is to say, the above parameters are in accordance with the following formula:

$$H = \frac{G}{2} - \sqrt{\left(\frac{G}{2}\right)^2 - \left(\frac{K}{2}\right)^2}$$

for example,

$$H = \frac{G1}{2} - \sqrt{\left(\frac{G1}{2}\right)^2 - \left(\frac{K}{2}\right)^2}, \quad H = \frac{G2}{2} - \sqrt{\left(\frac{G2}{2}\right)^2 - \left(\frac{K}{2}\right)^2}.$$

Based on the above fabrication method of the semiconductor device 100 of the examples of the present application, examples of the present application further provide a semiconductor device 100. The semiconductor device 100 in some examples of the present application comprises:

a stack structure 204, wherein the stack structure 204 comprises dielectric layers 30 and gate line layers 41 stacked alternately, and the stack structure 204 comprises first regions 202 and second regions 203;
channel structures 330 that are located in the first regions 202 and penetrate through the stack structure 204 along a first direction; and
gate line isolation structures 102 that are located in the second regions 203 and extend along a second direction, the gate line isolation structures 102 penetrating through the stack structure 204 along the first direction, and the gate line isolation structures 102 being in a concavo-convex shape along a third direction, wherein the second direction intersects the first direction, and the third direction intersects the first direction and the second direction.

In some examples of the present application, the material of the gate line layers 41 may include ruthenium (Ru), iridium (Ir), tungsten (W), tantalum (Ta), copper (Cu), aluminum (Al), doped silicon, silicide or a combination of any of one or more of the above materials.

It should be understood that, structures and fabrication processes of various constituent parts of the semiconductor device 100 in the examples of the present disclosure may refer to the above fabrication method examples of the semiconductor device 100, which is no longer repeated here.

In some examples, a protective layer 80 is disposed on top of the stack structure 204.

In some examples, the protective layer 80 includes polysilicon.

In some examples, the gate line isolation structures 102 comprise sidewalls extending along the second direction, wherein the sidewalls comprise a plurality of substructures 70 connected end to end, and two adjacent ones of the substructures 70 are not coplanar.

In some examples of the present application, it is to be noted that, the concavo-convex shape as described in the examples of the present application is a projection of the gate line isolation structures 102 on the bottom of the stack structure 204 or a surface of the substrate 50. A sidewall of the projection is not straight, but is a bent or curved line segment with a certain angle. In an example, the sidewalls in this example comprise the plurality of substructures 70 connected end to end along an extending direction of the gate line isolation structures 102, i.e., the second direction, and two adjacent ones of the substructures 70 are not coplanar.

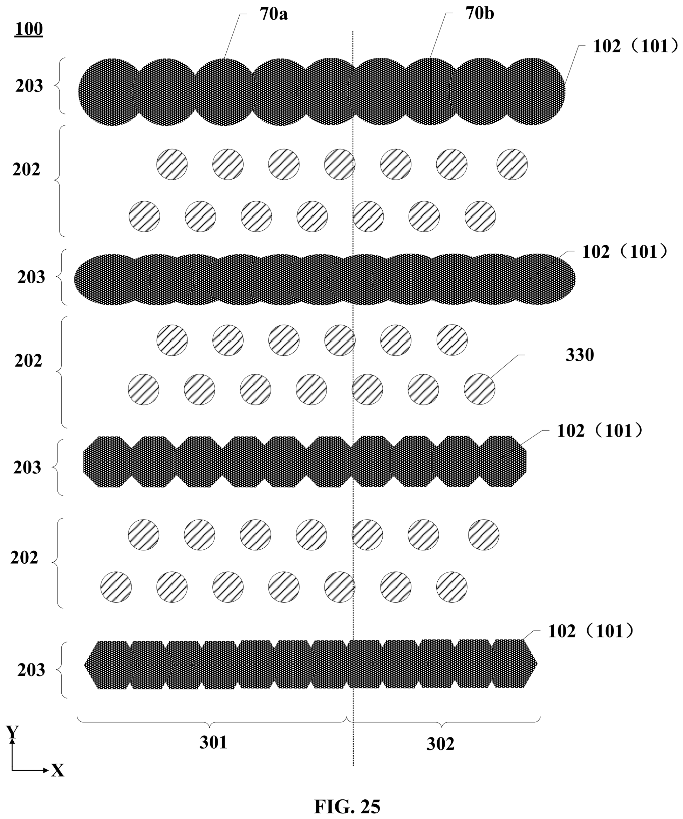

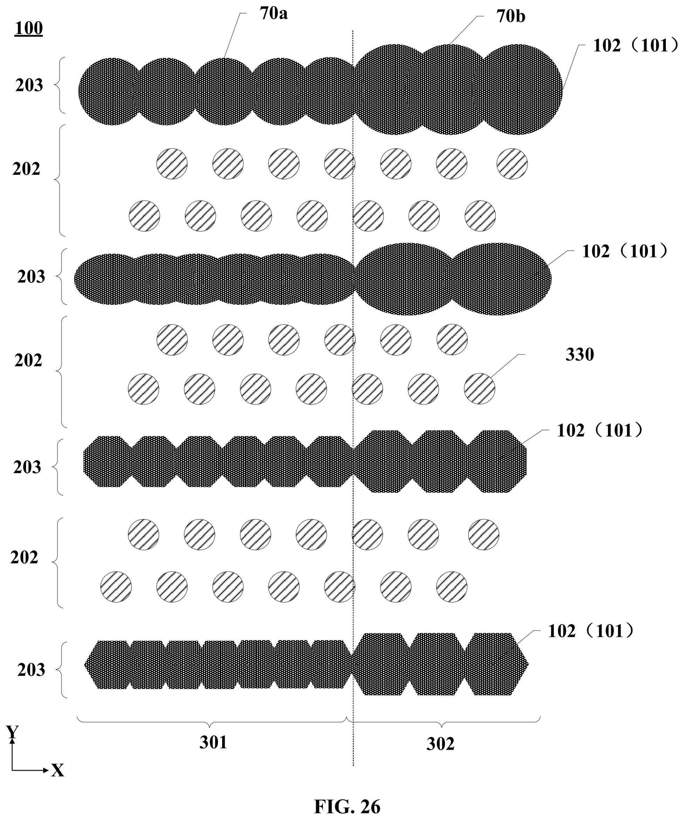

With continued reference to FIGs. 25 and 26, the shapes of the gate line isolation structures 102 provided in the examples of the present application are as shown in FIGs. 25 and 26, and a projection of the sidewalls of the gate line isolation structures 102 on the bottom surface of the stack structure 204 or the surface of the substrate 50 is a broken line or a curve consisting of a plurality of line segments. That is, in this example, by changing the shapes of the gate line isolation structures 102, the sidewalls of the gate line isolation structures 102 obtained finally are curved surfaces in a concavo-convex shape, i.e., structures formed by the plurality of substructures 70 having different directions. The concavo-convex shape is not specifically defined by the examples of the present application, and the concavo-convex shape includes concave parts and convex parts that are adjacent to each other. In an example, the concavo-convex shape may include a wavy shape with different curvatures, a broken line shape with different included angles, etc. as shown in FIGs. 25 and 26. It is to be noted that, FIGs. 25 and 26 only show examples of the shapes of the gate line isolation structures 102, and do not indicate that the gate line isolation structures 102 in various shapes as shown in FIGs. 25-26 have to be in the same semiconductor device 100 at the same time.

The bending directions of the plurality of substructures 70 are not limited by this example. Since a width of a position where the gate line trenches are disposed is large in the existing technology, the bending directions of the plurality of substructures 70 may be set according to the width of this position. Since the bending direction of each substructure 70 is different, and a material internal stress is perpendicular to the sidewalls of the gate line isolation structures 102, each substructure 70 itself has a corresponding material internal stress, and directions of the material internal stresses of the substructures 70 in different directions are different, and finally, the directions of the material internal stresses of multiple segments of the substructures 70 are not a single direction, thereby reducing a sum of the material internal stresses of the overall sidewalls of the gate line isolation structures 102, and avoiding the problem of device failure due to subsequent insufficient metal filling caused by tilting or distortion of the sidewalls of the gate line isolation structures 102 under large material internal stress.

Different from the design of the gate line isolation structures 102 as shown in FIG. 1, in the pattern design as shown in FIGs. 25 and 26, an initial strip-shaped gate line isolation structure 102 is designed as the gate line isolation structure 102 in a concavo-convex shape along the second direction. In the present application, the sidewalls of the gate line isolation structures 102 are set as curved surfaces in a concavo-convex shape, such that the direction of the material internal stress of each portion of the sidewalls perpendicular to the sidewalls is different, and the material internal stresses perpendicular to the sidewalls are not in a single direction, thereby reducing the degree of concentrated stress release and weakening extrusion force of the material internal stress to the sidewalls of the gate line isolation structures 102, so as to prevent the gate line isolation structures 102 from producing excessive deformation. As such, when stress mismatch of the gate line isolation structures 102 occurs, the stress can be effectively released through the gate line isolation structures 102 via the substructures 70 disposed in different directions. As a result, the gate line isolation structures 102 are not prone to tilting or distortion, whereby reducing leakage to increase the yield of finished products, and improving stability of the gate line isolation structures 102.

In some examples, the stack structure 204 comprises a core area 301 and a stair step area 302, wherein sizes of the gate line isolation structures 102 in the core area 301 along the third direction are equal to sizes of the gate line isolation structures 102 in the stair step area 302 along the third direction.

In some examples of the present application, the semiconductor device 100 may have the core area, the stair step area 302 and a periphery area (not shown in the figures). The core area 301 is a region for forming the memory cell, the stair step area 302 is a region for forming a word line connection circuit, and the periphery area is a region for forming a periphery circuit. Adjacent ones of the first regions 202 are separated by the gate line isolation structures 102 that may extend through the core area 301 and the stair step area 302.

Referring to FIGs. 23 to 25, in this example, both the core area 301 and the stair step area 302 of the stack structure 204 are provided with the gate line isolation structures 102 extending along the second direction, and the plurality of gate line isolation structures 102 penetrate through the stack structure 204 along the first direction to split the stack structure 204 into a plurality of portions. The sizes of the gate line isolation structures 102 in the core area 301 and the stair step area 302 along the third direction are the same. A process flow of forming the gate line isolation structures 102 in the core area 301 and the stair step area 302 of the stack structure 204 may refer to the examples corresponding to the operation S500 above, which are no longer repeated here.

In an example, as shown in FIG. 25, the shapes and sizes, along the X axis direction and the Y axis direction, of the plurality of substructures 70a in the core area 301 of the stack structure 204 and the plurality of substructures 70b in the stair step area 302 of the stack structure 204 are the same, and the plurality of substructures 70a of the core area 301 and the plurality of substructures 70b of the stair step area 302 are connected end to end along the X axis direction to form the gate line isolation structures 102 that are in a concavo-convex shape along the Y axis direction.

In some examples, the stack structure 204 comprises the core area 301 and the stair step area 302, wherein the sizes of the gate line isolation structures 102 in the core area 301 along the third direction are less than the sizes of the gate line isolation structures 102 in the stair step area 302 along the third direction.

In some examples of the present application, referring to FIG. 26, both the core area 301 and the stair step area 302 of the stack structure 204 in this example are provided with the gate line isolation structures 102 extending along the second direction, and the plurality of gate line isolation structures 102 penetrate through the stack structure 204 along the first direction to split the stack structure 204 into a plurality of portions. The sizes of the gate line isolation structures 102 in the core area 301 along the third direction are smaller than the sizes of the gate line isolation structures 102 in the stair step area 302 along the third direction. A process flow of forming the gate line isolation structures 102 in the core area 301 and the stair step area 302 of the stack structure 204 may refer to the examples above, which are no longer repeated here.

As shown in FIGs. 23, 24 and 26, widths (i.e., the sizes along the third direction) of the gate line isolation structures 102 in the stair step area 302 in this example are increased relative to widths (i.e., the sizes along the third direction) of the gate line isolation structures 102 in the core area 301. In the present application, additional operations or masks are not required to be added, and only the widths of the gate line isolation structures 102 on the top surface of the stair step area 302 are required to be increased, such that the widths of the bottoms of the gate line isolation structures 102 in the stair step area 302 can be increased accordingly. In the present application, increasing the widths of the gate line isolation structures 102 of the stair step area 302 contributes to uniform etching of the conductive material at the bottoms of the gate line isolation structures 102, and avoids accumulation of the conductive material at the bottoms of the gate line isolation structures 102 of the stair step area 302, thereby avoiding a short circuit or leakage current due to mutual interference between the adjacent ones of the gate line isolation structures 102.

In an example, as shown in FIG. 26, the shapes, along the X axis direction and the Y axis direction, of the plurality of substructures 70a in the core area 301 of the stack structure 204 and the plurality of substructures 70b in the stair step area 302 of the stack structure 204 are the same, but the size of each substructure 70a of the core area 301 along the Y axis direction is smaller than the size of each substructure 70b of the stair step area 302 along the Y axis direction. The plurality of substructures 70a of the core area 301 and the plurality of substructures 70b of the stair step area 302 are connected end to end along the X axis direction to form the gate line isolation structures 102 that are in a concavo-convex shape along the Y axis direction.

In some examples, the conductive material may include ruthenium (Ru), iridium (Ir), tungsten (W), tantalum (Ta), copper (Cu), aluminum (Al), doped silicon, silicide or a combination of any of one or more of the above materials. In an example, the conductive material may include tungsten (W).

In some examples, increasing the widths of the gate line isolation structures 102 may reduce separation distances between the gate line isolation structures 102 and adjacent structures (e.g., the channel structures 330 of the adjacent first regions 202), and the reduction of the separation distances results in increased etching risks, and leads to poor electrical contact between the gate line isolation structures 102 and the adjacent structures. In addition, more device space may also be occupied due to the increase of the widths of the gate line isolation structures 102, resulting in squeezing of occupied space of the channel structures 330, thus having an impact on the storage density of the device. In the examples of the present application, it is needed to at least consider and weigh the above two factors for the width design of the gate line isolation structures 102, so as to design suitable gate line isolation structure 102 widths for a specific device.

In this example, the gate line slit trenches 101 may be formed in the stack layer 201 located in the core area 301, and the gate line slit trenches 101 may also be formed in the stack layer 201 located in the stair step area 302, wherein the gate line slit trenches 101 extend along the second direction and penetrate through the stack layer 201 along the first direction, so as to split the stack layer 201 into several portions. In this example, after forming the gate line slit trenches 101, the gate line slit trenches 101 may be filled through a deposition process to form the gate line isolation structures 102. In some examples, the conductive material may be filled within the gate line slit trenches 101. In some examples, the gate line isolation structures 102 may penetrate through the stack structure 204, and extend to the substrate 50 but do not pass through the substrate 50.

In some examples, the gate line isolation structures 102 located in the core area 301 and the gate line isolation structures 102 located in the stair step area 302 may be formed in the same process, so as to achieve the objective of forming the gate line slit trenches 101 without additional cost.

It should be understood that, structures and fabrication processes of various constituent parts of the semiconductor device 100 in the examples of the present disclosure may refer to above examples of the fabrication method of the semiconductor device 100, which is no longer repeated here.

Based on the semiconductor device 100, the fabrication method thereof and the memory system above, examples of the present disclosure further provide a three-dimensional memory which comprises an array memory structure and a periphery circuit, wherein the array memory structure comprises the semiconductor device 100 of any one of the above examples.

In an example, the three-dimensional memory (a 3D NAND Flash) comprises an array memory structure and a periphery circuit, wherein the semiconductor device 100 of any one of the above examples is located in the array memory structure. The array memory structure is configured to store information, and the periphery circuit may be located above or below the array memory structure, and may also be located around the array memory structure. The periphery circuit is configured to control the corresponding array memory structure. In addition, the semiconductor device 100 may be further applied in other microelectronic devices, such as a Nor Flash, etc., which is not limited specifically. In addition, the semiconductor device 100 of the examples of the present disclosure may be a three-dimensional memory, and may be a part of a periphery memory, which is not limited particularly.

Based on the semiconductor device 100, the fabrication method thereof and the memory system above, examples of the present disclosure further provide a memory system which comprises a controller and a three-dimensional memory, wherein the controller is coupled to the three-dimensional memory and configured to control the three-dimensional memory to store data, and the three-dimensional memory comprises the semiconductor device 100 of any one of the above examples.

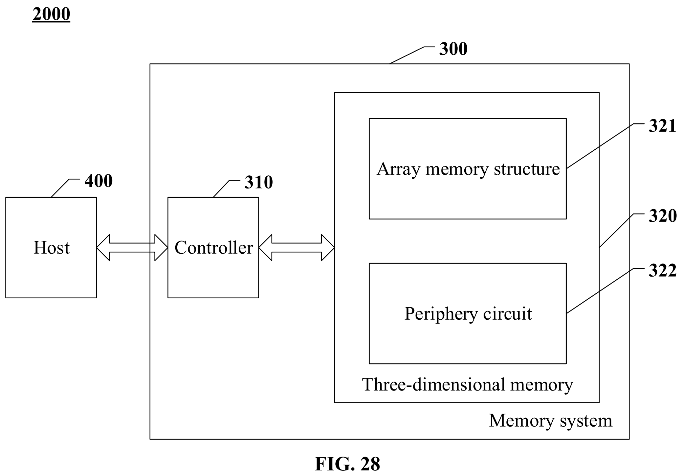

In an example, as shown in FIG. 28, the memory system 300 comprises the controller 310 and one or more three-dimensional memories 320, wherein each of the three-dimensional memories 320 comprises one or more array memory structures 321 and a periphery circuit 322. The memory system 300 may communicate with a host 400 through the controller 310, wherein the controller 310 may be connected to the one or more three-dimensional memories 320 via channels in the one or more three-dimensional memories 320. Each three-dimensional memory 320 may be managed by the controller 310 via the channel in the three-dimensional memory 320.

A semiconductor device, a fabrication method thereof, a memory, and a memory system provided by the examples of the present application are introduced above in detail. The principle and implementations of the present application are set forth by applying specific examples. The descriptions of the above examples are only to help understand the methods and core ideas of the present application. Meanwhile, for those skilled in the art, the specific implementations and application scopes may be changed according to the ideas of the present application. To sum up, the contents of this specification should not be interpreted as limitations to the present application.

## Claims

1. A fabrication method of a semiconductor device, comprising:

   providing a stack layer, wherein the stack layer comprises dielectric layers and sacrificial layers stacked alternately, and the stack layer comprises first regions and second regions;
   forming a plurality of channel holes penetrating through the stack layer along a first direction in the first regions, and forming a plurality of first dummy channel holes penetrating through the stack layer along the first direction in the second regions;
   forming a plurality of channel structures in the plurality of channel holes;
   forming gate line slit trenches that extend in a second direction and surround the plurality of first dummy channel holes, wherein the second direction intersects the first direction; and
   forming gate line isolation structures in the gate line slit trenches, wherein the gate line isolation structures are in a concavo-convex shape along a third direction that intersects the first direction and the second direction.

2. The fabrication method of the semiconductor device of claim 1, wherein the forming the gate line slit trenches that extend in the second direction and surround the plurality of first dummy channel holes comprises:
   etching the plurality of first dummy channel holes to form a plurality of second dummy channel holes, and connecting the plurality of second dummy channel holes together in the second direction to form the gate line slit trenches.

3. The fabrication method of the semiconductor device of claim 1, wherein before the forming the plurality of channel structures in the plurality of channel holes, the fabrication method further comprises:
   filling a sacrificial material in the channel holes and the first dummy channel holes, and removing the sacrificial material in the channel holes.

4. The fabrication method of the semiconductor device of claim 3, wherein after the filling the sacrificial material in the channel holes and the first dummy channel holes, and before the removing the sacrificial material in the channel holes, the fabrication method further comprises:
   forming a cap layer on top of the stack layer, and removing the cap layer above the channel holes.

5. The fabrication method of the semiconductor device of claim 4, wherein before the forming the gate line slit trenches that extend in the second direction and surround the plurality of first dummy channel holes, the fabrication method further comprises:
   removing the sacrificial material in the first dummy channel holes.

6. The fabrication method of the semiconductor device of claim 5, wherein after the forming the plurality of channel structures in the plurality of channel holes, and before the removing the sacrificial material in the first dummy channel holes, the fabrication method further comprises:
   forming a protective layer on top of the stack layer.

7. The fabrication method of the semiconductor device of claim 6, wherein the protective layer includes polysilicon.

8. The fabrication method of the semiconductor device of claim 1, wherein before the forming the gate line isolation structures in the gate line slit trenches, the fabrication method further comprises:
   replacing the sacrificial layers in the stack layer with gate line layers.

9. The fabrication method of the semiconductor device of claim 1, wherein shapes of the first dummy channel holes include any one of an ellipse or a circle, and shapes of the channel holes include a circle.

10. The fabrication method of the semiconductor device of claim 1, wherein the stack layer comprises a core area and a stair step area; and
    the plurality of first dummy channel holes with equal diameters along the third direction are formed in the core area and the stair step area.

11. The fabrication method of the semiconductor device of claim 1, wherein the stack layer comprises a core area and a stair step area; and
    diameters of the plurality of first dummy channel holes formed in the core area along the third direction are smaller than diameters of the plurality of first dummy channel holes formed in the stair step area along the third direction.

12. The fabrication method of the semiconductor device of claim 1, wherein the forming the plurality of channel holes penetrating through the stack layer along the first direction in the first regions and forming the plurality of first dummy channel holes penetrating through the stack layer along the first direction in the second regions comprises:

    forming a composite photolithography layer on the dielectric layer at the top of the stack layer, and forming a plurality of first trenches and a plurality of second trenches in the composite photolithography layer, wherein the first trenches are located within the first regions, and the second trenches are located within the second regions;
    etching the stack layer within the first regions through the first trenches to form the plurality of channel holes; and
    etching the stack layer within the second regions through the second trenches to form the plurality of first dummy channel holes.

13. The fabrication method of the semiconductor device of claim 12, wherein the plurality of channel holes and the plurality of first dummy channel holes are formed in the same process.

14. The fabrication method of the semiconductor device of claim 12, wherein the forming the composite photolithography layer on the dielectric layer at the top of the stack layer comprises:

    forming a stop layer on the dielectric layer at the top of the stack layer, and forming a first mask layer on the stop layer; and
    etching the first mask layer through the stop layer until exposing the dielectric layer at the top of the stack layer, so as to form the composite photolithography layer.

15. A semiconductor device, comprising:

    a stack structure, wherein the stack structure comprises dielectric layers and gate line layers stacked alternately, and the stack structure comprises first regions and second regions;
    channel structures that are located in the first regions and penetrate through the stack structure along a first direction; and
    gate line isolation structures that are located in the second regions and extend along a second direction, the gate line isolation structures penetrating through the stack structure along the first direction, and the gate line isolation structures being in a concavo-convex shape along a third direction, wherein the second direction intersects the first direction, and the third direction intersects the first direction and the second direction.

16. The semiconductor device of claim 15, further comprising: a protective layer disposed on top of the stack structure.

17. The semiconductor device of claim 15, wherein the gate line isolation structures comprise sidewalls extending along the second direction, the sidewalls comprise a plurality of substructures connected end to end, and two adjacent ones of the substructures are not coplanar.

18. The semiconductor device of claim 15, wherein the stack structure comprises a core area and a stair step area; and sizes of the gate line isolation structures located in the core area along the third direction are equal to sizes of the gate line isolation structures located in the stair step area along the third direction.

19. The semiconductor device of claim 15, wherein the stack structure comprises a core area and a stair step area; and sizes of the gate line isolation structures located in the core area along the third direction are smaller than sizes of the gate line isolation structures located in the stair step area along the third direction.

20. A memory system, comprising a controller and a three-dimensional memory, wherein the controller is coupled to the three-dimensional memory and configured to control the three-dimensional memory to store data, and the three-dimensional memory comprises the semiconductor device of any one of claims 15 to 19.

**100**

**33（330）**

**101（102）**

Y-Cut

X-Cut

Y

X

**FIG. 1**

FIG. 2

**100**  X-Cut  Y-Cut

330  101  330

201
（204）

Z
↑
└→X

202  203  203

Z
↑
Y←┘

**FIG. 3**

**100**

10
20
30
40

201
（204）

42
30

50

Z
↑
└→X

202  203  202  203  202

Z
↑
Y←┘

**FIG. 4**

**FIG. 5**

**FIG. 6**

FIG. 7

FIG. 8

FIG. 9

FIG. 10

**FIG. 11**

**FIG. 12**

FIG. 13

FIG. 14

**FIG. 15**

**FIG. 16**

**FIG. 17**

**FIG. 18**

**FIG. 19**

**FIG. 20**

**100**

**FIG. 21**

**100**

**FIG. 22**

**100**

**FIG. 23**

**100**

**FIG. 24**

**FIG. 25**

**FIG. 26**

| | |
|---|---|
| Provide a stack layer, wherein the stack layer comprises dielectric layers and sacrificial layers stacked alternately, and the stack layer comprises first regions and second regions | S100 |
| Form a plurality of channel holes penetrating through the stack layer along a first direction in the first regions, and form a plurality of first dummy channel holes penetrating through the stack layer along the first direction in the second regions | S200 |
| Form a plurality of channel structures in the plurality of channel holes | S300 |
| Form gate line slit trenches that extend in a second direction and surround the plurality of first dummy channel holes, wherein the second direction intersects the first direction | S400 |
| Form gate line isolation structures in the gate line slit trenches, wherein the gate line isolation structures are in a concavo-convex shape along a third direction that intersects the first direction and the second direction | S500 |

**FIG. 27**

**2000**

**300**

**321**

Array memory structure

**320**

**400** **310** **322**

Host ⟺ Controller ⟺ Array memory structure

Periphery circuit

Three-dimensional memory

Memory system

**FIG. 28**

## INTERNATIONAL SEARCH REPORT

| | International application No. |
|---|---|
| | **PCT/CN2023/093233** |

| **A.** | **CLASSIFICATION OF SUBJECT MATTER** |
|---|---|

H10B43/50(2023.01)i

According to International Patent Classification (IPC) or to both national classification and IPC

| **B.** | **FIELDS SEARCHED** |
|---|---|

Minimum documentation searched (classification system followed by classification symbols)

IPC: H10B, H01L

Documentation searched other than minimum documentation to the extent that such documents are included in the fields searched

Electronic data base consulted during the international search (name of data base and, where practicable, search terms used)

CNTXT; ENTXTC; DWPI; CNKI; ENTXT: 存储, 三维, 沟道, 虚拟, 栅线, 沟槽, 凹, 凸, 突, storage, three-dimensional, 3D, channel, virtual, gate, convex, protrusion

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | CN 114975467 A (YANGTZE MEMORY TECHNOLOGIES CO., LTD.) 30 August 2022 (2022-08-30) <br> description, paragraphs 2-96, and figures 1-9 | 1-20 |
| A | CN 115346998 A (SAMSUNG ELECTRONICS CO., LTD.) 15 November 2022 (2022-11-15) <br> entire document | 1-20 |
| A | US 2023057480 A1 (CHANGXIN MEMORY TECHNOLOGIES, INC. et al.) 23 February 2023 (2023-02-23) <br> entire document | 1-20 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **14 December 2023** | **19 December 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| | International application No. |
|---|---|
| | **PCT/CN2023/093233** |

| Patent document<br>cited in search report | | | Publication date<br>(day/month/year) | Patent family member(s) | Publication date<br>(day/month/year) |
|---|---|---|---|---|---|
| CN | 114975467 | A | 30 August 2022 | None | |
| CN | 115346998 | A | 15 November 2022 | None | |
| US | 2023057480 | A1 | 23 February 2023 | None | |

Form PCT/ISA/210 (patent family annex) (July 2022)